# EUROPÄISCHE PATENTSCHRIFT

(11) **EP 3 885 862 B1**
(45) Veröffentlichungstag und Bekanntmachung des Hinweises auf die Patenterteilung: **12.07.2023**
(21) Anmeldenummer: 20165853.1
(22) Anmeldetag: 26.03.2020
(51) Int. Cl.: G05B 23/02

(54) **VERFAHREN ZUR ZUSTANDSÜBERWACHUNG**
METHOD FOR STATUS MONITORING
PROCÉDÉ DE SURVEILLANCE D'ÉTAT

(43) Veröffentlichungstag der Anmeldung: 29.09.2021
(73) Patentinhaber: Siemens Aktiengesellschaft, 80333 München (DE)
(72) Erfinder: Niebler, Ludwig, 93164 Laaber (DE); Streich, Bernhard, 92224 Amberg (DE)
(74) Vertreter: Siemens Patent Attorneys

(56) Entgegenhaltungen:
- DE-A1-102018 203 669
- DE-C1- 19 546 553

## Beschreibung

Die Erfindung betrifft ein Verfahren zur Zustandsüberwachung von stromführenden elektrischen Komponenten. Ebenso betrifft die Erfindung eine Steuer- und Messeinrichtung, die zur Ausführung des Verfahrens ausgestattet ist. Gleichermaßen betrifft die Erfindung ein Computerprogrammprodukt, mit dem das Verfahren durchführbar ist.

Ungeplante Stillstandzeiten von technischen Anlagen, z. B. Montagelinien, Bandförderern oder Lüftungsanlagen, deren Ursachen oftmals ein Ausfall von Anlagenkomponenten durch Verschleiß sind, verursachen in der Regel für den Betreiber hohe Kosten. Bei den Betreibern von technischen Anlagen besteht deshalb das Interesse, einen kritischen Verschleiß einer Anlagenkomponente zu entdecken, noch bevor es zum Ausfall der Anlagenkomponente kommt, und die verschlissene Anlagenkomponente zu einem geeigneten Zeitpunkt vorbeugend zu ersetzen (Predictive Maintenance). Bei elektrisch betriebenen Anlagenkomponenten kann z. B. durch eine Beobachtung des Stroms, welcher dem elektrischen Antrieb zufließt, und durch einen Vergleich mit entsprechenden Werten zu früheren Zeitpunkten der aktuelle Verschleißzustand der Anlagenkomponente abgeschätzt werden. Bei elektromechanischen Schaltgeräten kann durch eine Zählung der Schaltspiele und eine Messung der geschalteten Stromstärke der Verschleißzustand approximiert werden.

US 10368451 B2 (Schneider Electric Industries SAS) 30.07.2019 beschreibt einen Verbindungsbaustein, mit dem ein Leistungsschalter mit einem Schütz elektrisch und mechanisch verbunden werden kann. Im Verbindungsbaustein ist ein Modul angeordnet, das den Stromfluss durch die elektrischen Verbindungsleitungen erfasst. Das Modul weist einen Prozessor und eine Bus-Schnittstelle auf, womit die gemessenen Stromwerte an eine übergeordnete Steuerung übertragen werden können. Mit solchen Stromwerten können Informationen über den Zustand eines angeschlossenen elektrischen Verbrauchers gewonnen werden, siehe z. B. EP 3361424 A1 (ABB Technology Oy) 15.08.2018, worin eine computerbasierte Methode beschrieben ist, mit der aus gemessenen Daten wie Stromstärke die verbleibende Lebensdauer eines elektrischen Verbrauchers abgeschätzt werden kann.

Die aus US 10368451 B2 bekannte Lösung hat jedoch den Nachteil, dass in jedem Abzweig für einen elektrischen Verbraucher ein derartiges Modul mit Strommessung, Prozessor und Schnittstelle angeordnet sein muss, um die entsprechenden Daten von dem zu überwachenden Verbraucher zu gewinnen. Das heißt, die Vorteile des in US10368451B2 beschriebenen Systems sind nur mit hohen Kosten zu erreichen.

DE 10 2018 203 669 A1 (Siemens AG) 12.09.2019 beschreibt ein Verfahren zum Überwachen einer Vielzahl von parallel geschalteten elektrischen Verbrauchern. Ein Strommessgerät erfasst einen zeitlichen Stromverlauf in einer Haupt-Versorgungsleitung, über die die Verbraucher mit Spannung versorgt werden. Das Strommessgerät misst wiederholt in einem vorgegebenen Zeitabstand die Stromstärke in der Haupt-Versorgungsleitung. Dabei wird von einer Auswerteeinheit geprüft, ob eine Abweichung des vom Strommessgerät erfassten Stromverlaufs gegenüber einem zeitlichen Referenz-Stromverlauf einen vorgegebenen Toleranzwert überschreitet.

DE 195 46 553 C1 (Mercedes-Benz AG) 07.05.1997 beschreibt ein Verfahren zum Prüfen von elektrischen Verbrauchern in einem Fahrzeug-Bordnetz, bei dem selektiv die von einer Fahrzeugbatterie gespeisten Verbraucher ein- und ausgeschaltet werden. Dabei wird jeweils die verbraucherspezifische Stromaufnahme im eingeschalteten Zustand ermittelt und bewertet. Dabei wird die Batteriespannung vor und nach dem Ausschalten eines zuvor eingeschalteten Verbrauchers gemessen und aus der verbraucherspezifischen Batteriespannungsdifferenz der verbraucherspezifische Stromaufnahmewert ermittelt.

Der Erfindung liegt daher die Aufgabe zugrunde, ein verbessertes Verfahren zur Zustandsüberwachung bereitzustellen.

Die Aufgabe wird gelöst durch ein Verfahren gemäß Anspruch 1.

Das Verfahren dient einer Zustandsüberwachung von mindestens einer von zwei oder mehr stromführenden elektrischen Komponenten. Die Zustandsüberwachung, engl.: Condition Monitoring, basiert auf einer regelmäßigen oder permanenten Erfassung des Zustandes einer stromführenden elektrischen Komponente, z. B. eines Schaltgeräts oder eines Elektromotors, oder des Zustandes einer von einer stromführenden elektrischen Komponente, insbesondere von einem Elektromotor, angetriebenen Anlagenkomponente, z. B. einer Maschine oder einer sonstigen technischen Anlage, durch Messung und Analyse elektrischer Größen, z. B. von Strom oder Spannung. Stromführende elektrischen Komponenten sind Komponenten, welche einen Stromfluss unterbrechen und/oder herstellen können (z. B. Schaltgeräte) und Maschinen (z. B. Elektromotoren), welche mittels eines Stromflusses eine Bewegung erzeugen können. Sowohl stromführende elektrischen Komponenten als auch Anlagen bzw. Anlagenkomponenten, welche von stromführenden elektrischen Komponenten angetrieben werden, werden im Folgenden auch unter dem Begriff "Verbraucher" zusammengefasst.

Die elektrische Energie wird der stromführenden elektrischen Komponente über eine Stromverteilungseinrichtung, welches elektrische Leitungen aufweist, aus einer elektrischen Energiequelle, z. B. einem Elektrizitätsnetz, zugeführt. Um den Transport der elektrischen Energie von der Energiequelle zu den stromführenden elektrischen Komponenten, d. h. einen Stromfluss, aufrecht zu erhalten, wird zwischen der elektrischen Energiequelle und den stromführenden elektrischen Komponenten eine elektrische Spannung angelegt.

Die Stromverteilungseinrichtung weist eine gemeinsame Stromeinspeisungsleitung und davon abzweigende separate Stromzuführungsleitungen auf. Der Stromfluss von der elektrischen Energiequelle zu den zwei oder mehr stromführenden elektrischen Komponenten verläuft in einem ersten Stromleitungsabschnitt über die gemeinsame Stromeinspeisungsleitung; gemeinsam bedeutet, dass der gesamte Stromfluss zu der Gesamtheit der zwei oder mehr stromführenden elektrischen Komponenten über diese Stromeinspeisungsleitung verläuft. Der Stromfluss von der gemeinsame Stromeinspeisungsleitung zu den zwei oder mehr stromführenden elektrischen Komponenten verläuft in einem dem ersten Stromleitungsabschnitt in Stromflussrichtung nachgelagerten zweiten Stromleitungsabschnitt jeweils über eine separate Stromzuführungsleitung. Jeder der zwei oder mehr stromführenden elektrischen Komponenten ist also eine separate Stromzuführungsleitung zugeordnet, welche mittels eines Schaltgeräts individuell stromsperrend (Schaltzustand des Schaltgeräts: offen) bzw. stromleitend (Schaltzustand des Schaltgeräts: geschlossen) geschaltet werden kann. Das Schalten der Stromzuführungsleitung in einen stromsperrenden Zustand, d. h. das Trennen einer elektrisch leitenden Verbindung, wird in dieser Beschreibung, analog zum entsprechenden offenen Schaltzustand des Schaltgeräts, kurz als Öffnen der Stromzuführungsleitung oder einfach als Öffnen bezeichnet. Das Schalten der Stromzuführungsleitung in einen stromleitenden Zustand, d. h. das Herstellen einer elektrisch leitenden Verbindung, wird in dieser Beschreibung, analog zum entsprechenden geschlossenen Schaltzustand des Schaltgeräts, kurz als Schließen der Stromzuführungsleitung oder einfach als Schließen bezeichnet. Das Öffnen, d. h. Unterbrechen des Stromflusses, und das Schließen, d. h. Herstellen und Aufrechterhalten des Stromflusses, einer separate Stromzuführungsleitung kann durch ein in die separate Stromzuführungsleitung eingefügtes Schaltgerät, welcher auf einem elektromechanischen und/oder elektronischen Schaltmechanismus beruht, erfolgen. Das Schaltgerät kann als ein Schütz oder ein leistungselektronisches Schaltelement, z. B. ein Transistor, ausgestaltet sein. Das Öffnen und das Schließen werden als Schaltvorgang bezeichnet, d. h. ein Schaltvorgang in einer Stromzuführungsleitung ändert den Zustand der Stromzuführungsleitung von stromsperrend zu stromleitend oder umgekehrt.

Die gemeinsame Stromeinspeisungsleitung und die separaten Stromzuführungsleitungen können für eine einphasige oder eine mehrphasige Stromleitung von einer elektrischen Energiequelle zu den zwei oder mehr stromführenden elektrischen Komponenten ausgestaltet sein. Für eine einphasige Stromleitung ist es ausreichend, wenn die gemeinsame Stromeinspeisungsleitung und die separaten Stromzuführungsleitungen jeweils einen einzigen Stromleiter und einen Stromrückleiter bzw. einen Neutralleiter aufweisen. Für eine dreiphasige Stromleitung, d. h. in einem Drehstromnetz für Dreiphasenwechselstrom, ist es ausreichend, wenn die gemeinsame Stromeinspeisungsleitung und die separaten Stromzuführungsleitungen jeweils drei getrennte Stromleiter - je ein Leiter für eine der drei Stromphasen - aufweisen; zusätzlich kann ein Neutralleiter vorhanden sein. Ein Stromleiter einer ein- oder mehrphasigen Stromleitung wird dabei auch als eine Strombahn bezeichnet. Ein Stromleiter einer mehrphasigen Stromleitung wird dabei auch als eine Stromphase bezeichnet.

Das Verfahren umfasst einen ersten Verfahrensschritt, in dem Messwerte mindestens einer elektrischen Größe in der gemeinsamen Stromeinspeisungsleitung vor und nach dem Strom sperrendschalten bzw. Stromsperrendschalten einer Stromzuführungsleitung erfasst werden. Dazu kann ein an der gemeinsamen Stromeinspeisungsleitung angeordneter Sensor der Steuer- und Messeinrichtung, z. B. ein Stromwandler oder ein Strommesswiderstand, Messwerte mindestens einer elektrischen Größe, z. B. eine Stromstärke oder eine Spannungsdifferenz, erfassen, welche in der gemeinsamen Stromeinspeisungsleitung vor und nach dem Schaltvorgang in einer oder mehrerer der Stromzuführungsleitungen, d.h. vor und nach dem Öffnen oder Schließen einer oder mehrerer der Stromzuführungsleitungen, auftreten. Auf Basis der erfassten mindestens einen elektrischen Größe können andere physikalische Größen, z. B. magnetischer Fluss, magnetische Flussdichte, Temperatur, hergeleitet werden.

Das Verfahren umfasst einen dem ersten Verfahrensschritt nachfolgenden zweiten Verfahrensschritt, in dem eine Differenz zwischen einem vor dem Schaltvorgang erfassten Messwert und einem nach dem Schaltvorgang erfassten Messwert berechnet wird. Im Fall, dass als Messwerte Stromstärken erfasst werden, wird diese Berechnung einer Differenz im Rahmen dieser Beschreibung als eine Differenzstrommessung bezeichnet. Dazu kann ein Prozessor der Steuer- und Messeinrichtung vom Sensor erfasste Messwerte, d. h. einen vor dem Schaltvorgang erfassten Messwert und einen nach dem Schaltvorgang erfassten Messwert, empfangen und daraus eine Differenz zwischen dem vor dem Schaltvorgang erfassten Messwert und dem nach dem Schaltvorgang erfassten Messwert berechnen.

Das Verfahren umfasst einen dem zweiten Verfahrensschritt nachfolgenden dritten Verfahrensschritt, in dem eine Zustandsveränderung mindestens einer der zwei oder mehr stromführenden elektrischen Komponenten auf Basis einer Zeitreihe der Differenzen ermittelt wird. Eine Zeitreihe ist eine zeitlich geordnete Folge von Differenzen einer bestimmten elektrischen Größe. Dazu kann der Prozessor der Steuer- und Messeinrichtung eine einem ersten Zeitpunkt zugeordnete Differenz mit mindestens einer einem von dem ersten Zeitpunkt abweichenden zweiten, dritten, usw. Zeitpunkt zugeordneten Differenz vergleichen und daraus eine Veränderung eines Zustands mindestens einer der zwei oder mehr stromführenden elektrischen Komponenten ableiten.

Eine Zeitreihe von Differenzen, gewonnen von einer stromführenden elektrischen Komponente kann als ein Footprint der stromführenden elektrischen Komponente bezeichnet werden; der Footprint charakterisiert also den Zustand der stromführenden elektrischen Komponente zu einem bestimmten Zeitpunkt. Über den Lebensdauerzyklus der stromführenden elektrischen Komponente entstehende Zustandsänderungen, d. h. Abweichungen eines aktuellen Footprint von einem Footprint der stromführenden elektrischen Komponente in einem früheren Zustand der stromführenden elektrischen Komponente können Hinweise auf einen einsetzenden Verschleiß der Komponente darstellen. Auf dieser Basis kann ein gezielter Service von einzelnen stromführenden elektrischen Komponenten vorgenommen werden.

Abgesehen von einem Verschleiß der stromführenden elektrischen Komponente selbst kann auch ein Verschleiß einer von der stromführenden elektrischen Komponente angetriebenen Anlagenkomponente die Ursache für Änderungen des Footprint sein. Es ist z. B. möglich, dass ein Anstieg eines von einem als ein Antrieb einer Anlage, z.B. eines Förderbands oder eines Lüfters, dienenden Elektromotor gezogenen Stroms ein Hinweis auf eine unerwünschte Schwergängigkeit bzw. Blockade der Anlage ist. Auf diese Weise kann durch eine Zustandsüberwachung einer stromführenden elektrischen Komponente, z. B. eines Elektromotors, auch eine Zustandsüberwachung einer durch den Elektromotor angetriebenen Anlagenkomponente erfolgen.

Auf Basis einer Zeitreihe von Differenzen können also Erkenntnisse über den Zustand der entsprechenden stromführenden elektrischen Komponente und/oder die elektrische Beanspruchung der stromführenden elektrischen Komponente, z. B. eines Stromschalters wie eines Schützes und/oder eines Elektromotors und/oder einer elektromotorisch angetriebenen Anlage wie eines Lüfters oder eines Förderbands, ermittelt werden. So kann z. B. die verbleibende Lebensdauer der stromführenden elektrischen Komponente oder einer durch die stromführende elektrische Komponente angetriebenen Anlagenkomponente errechnet werden. Damit besteht die Möglichkeit, rechtzeitig vor einem übermäßigen Verschleiß der stromführenden elektrischen Komponente oder der Anlagenkomponente eine Wartung der stromführenden elektrischen Komponente bzw. der Anlagenkomponente durchzuführen und dadurch einem unerwünschten Ausfall der stromführenden elektrischen Komponente bzw. der Anlagenkomponente und infolgedessen z. B. einem kostspieligen Anlagenstillstand zuvorzukommen.

Die skizzierte Aufgabenstellung wird auch durch eine erfindungsgemäße Steuer- und Messeinrichtung gelöst. Dabei weist die Steuer- und Messeinrichtung einen Sensor zum Erfassen von Messwerten einer elektrischen Größe in einer Stromeinspeisungsleitung vor und nach dem Schaltvorgang in einer oder mehrerer Stromzuführungsleitungen auf, wobei elektrischer Strom von einer elektrischen Energiequelle über die gemeinsame Stromeinspeisungsleitung und von der gemeinsamen Stromeinspeisungsleitung jeweils über eine separate Stromzuführungsleitung, die individuell geschaltet, d. h. geöffnet bzw. geschlossen, werden kann, zu zwei oder mehr stromführenden elektrischen Komponenten geführt wird. Und die Steuer- und Messeinrichtung weist einen Prozessor zum Berechnen einer Differenz zwischen einem vor dem Schaltvorgang erfassten Messwert und einem nach dem Schaltvorgang erfassten Messwert und zum Ermitteln einer Zustandsveränderung mindestens einer der zwei oder mehr Komponenten auf Basis einer Zeitreihe von Differenzen auf.

Die Steuer- und Messeinrichtung kann wie folgt charakterisiert werden: Ein Prozessor steuert Schaltgeräte, die in einer Stromverteilungseinrichtung Stromflüsse öffnen und schließen. In der Stromverteilungseinrichtung durch einen oder mehrere Sensoren gewonnene Messwerte in Bezug auf die Stromflüsse werden dem Prozessor zugeführt. Weder der Datenfluss zwischen dem Sensor und dem Prozessor noch zwischen dem Prozessor und den Schaltgeräten zum Schalten, d. h. Öffnen und Schließen, des Stromflusses in den Stromzuführungsleitungen erfolgt mittels eines Datenbusses. Für die Kalkulation des Verschleißzustandes einer stromführenden elektrischen Komponente und/oder einer durch die stromführenden elektrischen Komponente angetriebenen Anlagenkomponente wird der Strom-Zeit-Verlauf und/oder der Spannungs-Zeit-Verlauf unmittelbar nach dem Zu- und/oder Abschalten eines Stromflusses zu der stromführenden elektrischen Komponente erfasst und ausgewertet.

Ein besonderer Vorteil der Erfindung liegt darin, dass eine Steuer- und Messeinrichtung, welche einen Sensor, d. h. eine Messwerterfassungseinrichtung, und einen Prozessor aufweist, Messwerte mindestens einer elektrischen Größe in Bezug auf mehrere statt nur einer stromführenden elektrischen Komponente erfasst und vorzugsweise zum Großteil schon verarbeitet bzw. vorverarbeitet; somit verteilen sich die Kosten für die Steuer- und Messeinrichtung auf mehrere stromführende elektrische Komponenten, und die Kosten pro stromführender elektrischer Komponente sind geringer als wenn jede stromführende elektrische Komponente einzeln durch eine separate Steuer- und Messeinrichtung überwacht würde. Die Kosten sind umso geringer, je mehr stromführende elektrische Komponenten, die in einer Stromverteilungseinrichtung zusammengefasst sind, von einer einzigen Steuer- und Messeinrichtung überwacht werden. Die Erfindung reduziert also den Einsatz von Überwachungskomponenten für das Erfassen von elektrischen Daten in technischen Anlagen und verringert damit die für eine Zustandsüberwachung anfallenden Kosten.

Die Steuer- und Messeinrichtung weist einen Prozessor zum Abarbeiten eines Programms zur Ausführung des erfindungsgemäßen Verfahrens auf. Zusätzlich weist die Steuer- und Messeinrichtung eine Messwerterfassungseinheit, also einen Sensor, zur Spannungs- und/oder Stromüberwachung einer ein- oder mehrphasigen Stromleitung auf, welche in der für alle in der Stromverteilungseinrichtung vorhandenen stromführenden elektrischen Komponenten, z. B. elektrische Verbraucher, vorgesehenen Stromeinspeisungsleitung platziert ist. Durch intelligentes Schalten der stromführenden elektrischen Komponenten kann in der Steuer- und Messeinrichtung für jede stromführende elektrische Komponenten ein "Footprint" erstellt werden. Über den Lebensdauerzyklus können Änderungen des "Footprint" als Auslöser für eine gezielte vorausschauende Wartung der einzelnen stromführenden elektrischen Komponenten bzw. der von ihnen angetriebenen Anlagenkomponenten dienen.

Eine Besonderheit der Erfindung ist, dass in einer für zwei oder mehr Verbraucher gemeinsamen Stromeinspeisungsleitung einer Stromverteilungseinrichtung für die Verbraucher ein zur Messung von Strom und/oder Spannung geeigneter Sensor gekoppelt mit einem Prozessor mit einer vorzugsweise hohen Messrate eingebracht ist. Der Sensor ist direkt, also nicht über einen eventuell zeitverzögernden Datenbus, an den Prozessor angeschlossen, welcher auch Schaltgeräte zum Schalten der von der gemeinsamen Stromeinspeisungsleitung zu den Verbrauchern führenden Stromzuführungsleitungen steuert, d.h. ein- und ausschaltet. Die Schaltgeräte werden ebenfalls direkt, also nicht über einen eventuell zeitverzögernden Datenbus, von dem Prozessor angesteuert.

Gemäß einer bevorzugten Ausgestaltung der Erfindung weist die Steuer- und Messeinrichtung einen Speicher, d. h. einen Datenspeicher, auf, d. h. dem Prozessor ist ein Datenspeicher zugeordnet, in dem die vom Sensor gewonnenen Messwerte zwischengespeichert werden können. Auf diese Weise steht der Steuer- und Messeinrichtung ein Datenpuffer zur Zwischenspeicherung zur Verfügung, so dass eine Weiterleitung der Messwerte zu einer übergeordneten Steuerung verzögert werden und erst zu einem späteren Zeitpunkt, dann eventuell als ein größerer Datensatz umfassend eine Vielzahl von Messwerten, erfolgen kann. Der Speicher der Steuer- und Messeinrichtung kann also eine separate Gerätekomponente bereitgestellt sein oder in eine andere Gerätekomponente mit integriert sein. Der Datenspeicher der Steuer- und Messeinrichtung macht es aufgrund seiner Funktion als Zwischenpuffer möglich, dass zur Übertragung von ggf. vorverarbeiteten Messwerten zu einer übergeordneten Steuerung ein Datenbus Verwendung findet, der ja nur zu festgelegten Buszykluszeiten eine Datenübertragung erlaubt. Außerdem können vom Sensor erfasste Messwerte vom Prozessor vorverarbeitet und als Zwischenergebnis im Speicher zwischengespeichert werden, bis das Zwischenergebnis, welches vorzugsweise gegenüber den ursprünglichen Messwerten ein signifikant geringeres Datenvolumen aufweist, zu einem späteren Zeitpunkt zu einer übergeordneten Steuerung übertragen werden. Der Speicher kann z. B. in Form eines Halbleiterspeichers ausgebildet sein.

Gemäß einer bevorzugten Ausgestaltung der Erfindung weist die Steuer- und Messeinrichtung eine Kommunikationsschnittstelle zur Übertragung von erfassten Messwerten in ein Kommunikationsnetzwerk auf. Die Kommunikationsschnittstelle, z. B. in Form einer Schnittstelleneinheit, dient zur Kommunikation des Prozessors mit einem Kommunikationsnetzwerk, z. B. via eines Datenbussystems. Die Kommunikation zwischen dem Prozessor und dem Kommunikationsnetzwerk über die Kommunikationsschnittstelle muss nicht nach jedem Eingang, in den Prozessor, eines durch den Sensor erfassten Messwertes oder vor jedem Ausgang, aus dem Prozessor, eines Steuerbefehls zur Ansteuerung eines in einer Stromzuführungsleitung angeordneten Schaltgeräts zum Öffnen bzw. Schließen der entsprechenden Stromzuführungsleitung erfolgen, sondern blockweise nach einer vorgegebenen Zykluszeit oder gemäß einem vorgegebenen Algorithmus, nachdem ein Fehlerevent ermittelt wird. Als Fehlerevent wird ein Hinweis auf eine Zustandsveränderung, z. B. infolge von einsetzendem Verschleiß, einer Komponente verstanden, wobei der Hinweis in Form einer sich verändernden Zeitreihe von Differenzen vorliegt. Trifft ein Fehlerevent ein, so kann eine Meldung über eine Datenleitung, z. B. einen Datenbus, an eine übergeordnete Steuerung, die vorzugsweise in dem Kommunikationsnetzwerk angeordnet ist, kommuniziert. Eine Busreaktionszeit eines Datenbusses hat somit keinen Einfluss auf eine Verarbeitung von Daten in Bezug auf eine stromführende elektrische Komponente.

Die einzelnen Footprints der Verbraucher werden durch Differenzstrommessung ermittelt und in der Steuer- und Messeinrichtung, insbesondere einem Speicher der Steuer- und Messeinrichtung, abgespeichert. Es ist auch möglich, dass ein Footprint, der zu einem früheren Zeitpunkt erfasst wurde, z. B. während einer Prüfung in der Qualitätskontrolle des Herstellers, während eines vor der Auslieferung an einen Betreiber eines Verbrauchers durch den Hersteller durchgeführten Funktionstest des Verbrauchers, oder unmittelbar nach der Inbetriebnahme des Verbrauchers bei einem Betreiber des Verbrauchers, in einem Speicher hinterlegt ist, so dass er als Referenz in einem Vergleich mit später ermittelten Messwerten des Verbrauchers herangezogen werden kann. Solche Footprints können z. B. in einem dem Verbraucher beigefügten Speicher abgelegt sein, aus dem sie in die Steuer- und Messeinrichtung hochgeladen werden können. Solche Footprints können z. B. auch über eine Kommunikationsschnittstelle der Steuer- und Messeinrichtung von einem öffentlich zugänglichen Speicher, z. B. einer Website des Herstellers des Verbrauchers, heruntergeladen werden. Es ist auch möglich, dass ein solcher als Referenz dienender Footprint manuell in einen Speicher eingegeben wird, indem den Verbraucher charakterisierende Werte, z. B. ein Nennstrom, anhand von Datenblättern, Herstellerangaben, Handbüchern, Referenzwerken, etc. übertragen werden.

Die Ermittlung von Footprints erfolgt fortlaufend über den Lebensdauerzyklus eines Verbrauchers. Jeder ermittelte Footprint wird mit einem früheren abgespeichertem Footprint verglichen. Wird eine Abweichung ermittelt, kann gezielt für diesen Verbraucher ein Service vorgenommen werden. Wird z. B. eine Abweichung eines aktuellen Footprint von einem zuvor gespeicherten Footprint festgestellt, so kann diese Abweichung a) von einer Analyse-Software in der Steuer- und Messeinrichtung oder b) von einer übergeordneten Steuerung in dem Kommunikationsnetzwerk interpretiert werden. Im ersten Fall kann das analysierte Ergebnis über eine Datenleitung, z. B. einen Datenbus, an eine übergeordnete Steuerung in dem Kommunikationsnetzwerk weitergegeben werden. Im zweiten Fall ist es möglich, dass in der Steuer- und Messeinrichtung lediglich vom gespeicherten Footprint abweichende Daten ermittelt (Vorverarbeitung) und diese Abweichungen über eine Datenleitung, z. B. einen Datenbus, an eine übergeordnete Steuerung übertragen werden; in der übergeordnete Steuerung kann dann die Interpretation erfolgen. Beide Analyse-Prozesse verfolgen das Ziel, im Verbraucher frühzeitig einen Verschleiß festzustellen, um rechtzeitig eine Wartung bzw. einen Service vornehmen zu können. Der Begriff Analyse-Software schließt Analyse-Firmware mit ein.

Gemäß der Erfindung werden die Messwerte in einem ersten Zeitfenster vor und in einem zweiten Zeitfenster nach dem Schaltvorgang in der einen oder mehreren Stromzuführungsleitungen erfasst. Ein Zeitfenster ist ein Zeitraum mit einem definierten Start- und Endzeitpunkt, d. h. mit einer definierten Dauer. In mindestens einem ersten Zeitfenster vor dem Schaltvorgang wird mindestens ein Messwert in der gemeinsamen Stromeinspeisungsleitung erfasst. In mindestens einem zweiten Zeitfenster nach dem Schaltvorgang wird mindestens ein Messwert in der gemeinsamen Stromeinspeisungsleitung erfasst. Durch Differenzbildung zwischen den vor und nach dem Schaltvorgang erfassten Messwerten wird ermittelt, welche Veränderung die erfasste elektrische Größe in den durch den Schaltvorgang betroffenen Stromzuführungsleitungen erfährt. Die Erfassung der Messwerte in den Zeitfenstern erfolgt mit definierten Messraten, d. h. mit einer definierten Zahl von Messungen pro Zeiteinheit. Der Vorteil ist, dass die Gewinnung von Messwerten an die jeweilige Änderungsrate der zu erfassenden elektrischen Größen oder an ein Zeitintervall, in dem am besten Aussagen über die interessierenden Komponenten erzielt werden können, angepasst werden kann: ein Zeitfenster wird vorzugsweise in einem zeitlichen Bereich geöffnet, wo die Messwerte Aussagen über eine jeweilige Komponente, z.B. einen Elektromotor, ein Schaltgerät oder eine Applikation wie ein Förderband, erlauben.

Gemäß einer bevorzugten Ausgestaltung der Erfindung wird die Einstellung der Parameter der Zeitfenster abhängig davon gewählt, in welcher Applikation die zwei oder mehr stromführenden elektrischen Komponenten betrieben werden. Der Vorteil ist, dass die Gewinnung von Messwerten applikationsbezogen individuell an die jeweilige Änderungsrate der zu erfassenden elektrischen Größen angepasst werden kann. Beispielsweise ist der Einschaltrush nur unmittelbar nach dem Einschalten eines Elektromotors messbar; ein entsprechendes Zeitfenster muss also direkt zum Einschaltzeitpunkt beginnen, eine hohe Messrate aufweisen und kann bereits nach wenigen Millisekunden wieder enden, sobald der Einschaltrush beendet ist. Andererseits ist es zur Zustandsüberwachung eines Lagers einer von einem Elektromotor betriebenen mechanischen Applikation nicht erforderlich, das Zeitfenster über den Einschaltrush des Elektromotors zu legen; hier ist es sinnvoller, das Zeitfenster zu einem späteren Zeitpunkt beginnen zu lassen, wenn der Elektromotor einen eingeschwungenen Zustand erreicht hat, wo anhand einer leicht erhöhten Stromstärke auf eine andauernde erhöhte Last des Elektromotors wegen des verschlissenen Lagers geschlossen werden kann.

Gemäß der Erfindung sind Parameter der Zeitfenster einstellbar. Parameter der Zeitfenster sind insbesondere die Länge der Zeitfenster, d. h. der zeitliche Abstand der Start- und Endzeitpunkte der Zeitfenster, und der zeitliche Abstand der Zeitfenster zu einem Zeitpunkt des Schaltvorgangs, z. B. zu einem Startzeitpunkt des Schaltvorgangs oder einem Zeitpunkt, an dem ein Steuerbefehl zum Starten des Schaltvorgangs von der Steuer- und Messeinrichtung an ein Schaltgerät gesendet wird. Auch die Messraten in den Zeitfenstern sind Parameter der Zeitfenster. Der Vorteil ist, dass die Gewinnung von Messwerten an die jeweilige Änderungsrate der zu erfassenden elektrischen Größen oder an ein Zeitintervall, in dem am besten Aussagen über die interessierenden Komponenten erzielt werden können, angepasst werden kann.

Gemäß einer bevorzugten Ausgestaltung der Erfindung sind die Parameter der Zeitfenster applikationsabhängig in einem Speicher hinterlegt. Es kann z. B. im Speicher eine Tabelle hinterlegt sein, in der für unterschiedliche Verbraucher und Applikationen Parameter von Zeitfenstern, die für eine Zustandsüberwachung des jeweiligen Verbrauchers und/oder der jeweiligen Applikationen geeignet sind, hinterlegt sind. Der Betrieb einer bestimmten Applikation kann ein Schalten unterschiedlicher Verbraucher gemäß einem Betriebsplan zu definierten Zeitpunkten erfordern, z. B. der Betrieb einer Förderanlage mit einer Vielzahl von Förderbändern antreibenden Elektromotoren. Dieser mehrere Verbraucher, hier: Elektromotoren, steuernde Betriebsplan kann nun ein oder mehrere geeignete Zeitpunkte und Zeitintervalle aufweisen, an denen eine Erfassung von Messwerten zu erfolgen hat, wenn Informationen über einen Zustand eines bestimmten Verbrauchers, z.B. eines Schaltgeräts, eines Elektromotors, oder einer durch den Elektromotor angetriebenen Applikation, gewonnen werden sollen. Der Vorteil ist, dass die Zustandsüberwachung in einem System mit einer Vielzahl von Verbrauchern sehr vereinfacht wird, da für eine Zustandsüberwachung eines beliebigen Verbrauchers, der über eine Stromverteilungseinrichtung mit Strom versorgt wird, nur vordefinierte Werte aus der Tabelle ausgelesen werden und der Messung zugrunde gelegt werden müssen.

Gemäß einer bevorzugten Ausgestaltung der Erfindung steuert der Prozessor die ihm zugeordneten Schaltgeräte mit einem zeitlichen Versatz. Nach einem Öffnen oder einem Schließen einer Stromzuführungsleitung zu einer stromführenden elektrischen Komponente vergeht eine bestimmte Zeitspanne, bis die stromführende elektrische Komponente bzw. der Stromfluss in der stromführende elektrische Komponente wieder in einen eingeschwungenen Zustand gelangt ist. Beispielsweise tritt beim Einschalten eines Elektromotors der sogenannte Einschaltrush, d. h. ein stark erhöhter Einschaltstrom, auf. Würde nun bereits während des Einschaltrush eines über eine erste Stromzuführungsleitung versorgten ersten Elektromotors ein über eine zweite Stromzuführungsleitung versorgter zweiter Elektromotor eingeschaltet, so überlagerten sich die Stromkurven beider Elektromotoren während ihres jeweiligen Einschaltrush und es wäre unmöglich, einen von einem Referenz-Stromverlauf abweichenden und auf einen Verschleiß eines Elektromotors hinweisenden Stromverlauf einem der beiden Elektromotoren zuzuordnen. Daher steuert der Prozessor die ihm zugeordneten Schaltgeräte mit einem zeitlichen Versatz so an, dass der interessierende Stromverlauf einer ersten stromführende elektrische Komponente beendet ist bevor der der interessierende Stromverlauf einer zweiten stromführenden elektrischen Komponente einsetzt. Auf diese Weise wird eine eindeutige Ermittlung der Leistungsdaten bzw. elektrischen Daten eines einzelnen Verbrauchers mittels Stromdifferenzmessung sichergestellt. Der Zeitversatz wird ausreichend groß gewählt, so dass eine eindeutige Zuordenbarkeit von gemessenen Stromwerten zu einer stromführenden elektrischen Komponente sichergestellt ist. Der Zeitversatz wird andererseits ausreichend klein gewählt, so dass die Einschaltzeitpunkte im realen Betrieb als praktisch gleichzeitig wahrgenommen werden. Mit anderen Worten: das erfindungsgemäße Verfahren kann durchgeführt werden, ohne einen Betrieb einer Anlage zu stören. Dabei kann ein zweiter Schaltzeitpunkt zum Einschalten einer zweiten stromführende elektrische Komponente mit einer Verzögerung von z. B. 25 ms nach einem ersten Schaltzeitpunkt zum Einschalten einer ersten stromführende elektrische Komponente erfolgen.

Gemäß einer bevorzugten Ausgestaltung der Erfindung erfolgt das Erfassen von Messwerten einer elektrischen Größe in der gemeinsamen Stromeinspeisungsleitung mit einer Frequenz im Bereich von 100 bis 10.000 Messungen pro Sekunde. Der Vorteil ist, dass auch sich schnell vollziehende Vorgänge wie ein Einschaltrush mit einer so hohen zeitlichen Auflösung erfasst werden können, dass eine ausreichend große Anzahl von Messwerten für eine detaillierte Differenzwertbildung vorliegen.

Es ist möglich, dass Zeitfenster unterschiedlicher Länge definiert werden, in denen vom Sensor Messwerte an der gemeinsamen Stromeinspeisungsleitung erfasst werden. Ein erstes Zeitfenster kann vor und ein zweites Zeitfenster nach einem Schaltzeitpunkt eines in einer Stromzuführungsleitung angeordneten Schaltgerätes definiert werden. Dabei kann das Zeitfenster zum Monitoring des Stromverlaufs nach einem ersten Schaltzeitpunkt zum Einschalten eines ersten Elektromotors z. B. eine Länge von 5 ms aufweisen. Innerhalb eines Zeitfensters kann der Sensor mit einer Periode von z. B. 0,1 ms Messwerte erfassen. Ein 5 ms langes Zeitfenster zum Monitoring des Stromverlaufs nach dem Einschalten eines Elektromotors würde somit zu fünfzig Messwerten führen. Diese fünfzig Messwerte definieren einen "Footprint" des Elektromotors.

Gemäß einer bevorzugten Ausgestaltung der Erfindung ermittelt der Prozessor nach jedem Steuerbefehl an ein Schütz die Differenz der neuen Werte zu den Werten, die vor dem Steuerbefehl gemessen wurden. Durch diese Vorverarbeitung der Messwerte im Prozessor verringert sich die Menge an Daten, die zur Datenanalyse zu einem Prozessor zur Weiterverarbeitung der Messwerte übertragen werden müssen.

Gemäß einer bevorzugten Ausgestaltung der Erfindung werden die so errechneten Differenzwerte zwischengespeichert, vom Prozessor weiterverarbeitet, oder über eine Kommunikationsschnittstelle an einen Prozessor zur Weiterverarbeitung der Messwerte, vorzugsweise eine übergeordnete Steuerung, weitergegeben. Durch eine Zwischenspeicherung kann die Datenübertragung trotz einer Zykluszeit eines Datenbusses sichergestellt werden. Es ist möglich, dass in einem Kommunikationsnetz, z.B. in einer cloud-basierten IoT-Plattform wie Mindsphere^{®}, bessere Analysemöglichkeiten bestehen als in einem isoliert arbeitenden Prozessor.

Gemäß einer bevorzugten Ausgestaltung der Erfindung erfolgt eine Übertragung von erfassten Messwerten von einem Sensor zum Erfassen der Messwerte zu dem Prozessor, vorzugsweise zur Weiterverarbeitung der Messwerte, über eine ungetaktete direkte Kommunikationsverbindung. Eine Anordnung ohne Datenbus ist wichtig, um reproduzierbare Zeitfenster zu erlangen, in denen die Differenzwerte ermittelt werden.

Gemäß einer bevorzugten Ausgestaltung der Erfindung können in der weiteren Verarbeitung der Differenzwerte Erkenntnisse über den Zustand des entsprechenden elektrischen Verbrauchers und/oder die elektrische Beanspruchung des Schaltgerätes bzw. auch des Verbrauchers ermittelt werden. So kann z. B. die verbleibende Lebensdauer eines Schützes errechnet werden. Damit besteht die Möglichkeit, rechtzeitig vor Verschleiß einen Service durchzuführen und damit kann eine längeren Anlagenstillstand zu verhindern.

Gemäß einer bevorzugten Ausgestaltung der Erfindung werden mit einer Analyse-Software weitere Analysen von einem Verbraucherabzweig gemacht. Die Kosten für die Hardware bleiben dabei sehr begrenzt.

Bei einem elektromechanisch betätigten Schaltgerät, z. B. einem Schütz, dessen Hauptkontakte einen Drehstrom schalten, hängt die Belastung der Schaltkontakte davon ab, zu welchem exakten Zeitpunkt die Kontakte öffnen oder schließen. Die elektrische Belastung der Kontakte und damit auch deren Abbrand durch den beim Öffnen oder Schließen entstehenden Lichtbogen hängt wesentlich von der zum Zeitpunkt der Kontaktöffnung oder des Kontaktschließens vorliegenden Phase der Netzspannungen oder -ströme ab. Wird mit dem Schaltgerät ein Drehstromsystem, beispielsweise ein Drehstrommotor geschaltet, und wird der elektromechanische Antrieb mit einer Gleichspannung betrieben, die zufällig an- und ausgeschaltet wird, ergibt sich für jeden der Kontakte eine Gleichverteilung der Schaltwinkel, d. h. für jeden Kontakt kommt jede Phasenlage gleich häufig vor. Daraus ergibt sich für alle Kontakte des Schaltgerätes ein gleichmäßiger Abbrand, weil jeder Kontakt dieselbe Mischung aus Schaltvorgängen mit niedrigem und hohem Abbrand erlebt.

Wird der Antrieb des Schaltgerätes mit Wechselspannung oder mit einer gleichgerichteten Wechselspannung betrieben, hängen die Abläufe der Schließ- und Öffnungsvorgänge zusätzlich davon ab, welche Phasenlage die Versorgungsspannung des elektromechanischen Antriebs zum Zeitpunkt seines Betätigens aufweist. In der Praxis werden auch bei einer Gleichverteilung der Phasenlage der Versorgungsspannung des Antriebs bei dessen Ein- und Ausschalten für jeden der drei Hauptkontakte sehr unterschiedliche Häufigkeiten in der Phase der Lastspannung bzw. -ströme beobachtet. Dieser Effekt wird als Selbstsynchronisation bezeichnet.

Zusätzlich zu dieser Selbstsynchronisation wird in der Praxis auch häufig eine Fremdsynchronisation beobachtet, bei denen bereits eine ungleichmäßig verteilte Phasenlage der Versorgungsspannung beim Ein- bzw. Ausschalten des Antriebs eine Synchronisation der Schaltvorgänge hervorruft. Eine solche Fremdsynchronisation kann auch von einer elektronischen Steuerung verursacht werden, wenn sich in der zeitlichen Abfolge zwischen Schaltbefehl und Ein- bzw. Ausschalten der Versorgungsspannung des Antriebs Abhängigkeiten zur Phasenlage des Netzes ergeben. Im Extremfall tritt nur ein vorbestimmter Schaltwinkel auf.

Gemäß einer bevorzugten Ausgestaltung der Erfindung wird bei einem mehrphasigen Drehstrom durch ein Auswerten der Stromstärke in den einzelnen Strombahnen, d. h. dem jeweiligen Stromleiter für eine der mehreren Stromphasen, ein Synchronisationseffekt erkannt und in Reaktion darauf der Schaltverzug zwischen den Strombahnen so verändert, dass im Schaltgerät die Kontakte gleichmäßig verschleißen. Der Vorteil dabei ist, dass die elektrische Lebensdauer des Schaltgerät gegenüber der eines Schaltgeräts ohne eine Veränderung des Schaltverzugs bis zu verdoppelt werden kann. Hinsichtlich bekannter Verfahren zur Vermeidung des Synchronisationseffekts wird verwiesen auf DE 19948551 C1 (Siemens AG) 05.07.2001 und DE 102005043895 B4 (Siemens AG) 15.03.2007.

Die skizzierte Aufgabenstellung wird auch durch ein erfindungsgemäßes Computerprogrammprodukt gelöst. Computerprogrammprodukt (80) zur Zustandsüberwachung von mindestens einer von zwei oder mehr stromführenden elektrischen Komponenten (18.1, 18.2, 18.3, 41, 42, 43), wobei das Computerprogrammprodukt (80) in einem Prozessor (6) einer Steuer- und Messeinrichtung (3) ausführbar Das Computerprogrammprodukt ist in zumindest einem Prozessor der Steuer- und Messeinrichtung ausführbar ausgebildet. Das Computerprogrammprodukt kann als Software, z. B. als eine aus dem Internet herunterladbare App, oder als Firmware in einem Speicher der Steuer- und Messeinrichtung speicherbar und durch den Prozessor oder ein Rechenwerk ausführbar ausgebildet sein. Alternativ oder ergänzend kann das Computerprogrammprodukt auch zumindest teilweise als festverdrahtete Schaltung ausgebildet sein, beispielsweise als ein ASIC (ASIC = Application-Specific Integrated Circuit). Das erfindungsgemäße Computerprogrammprodukt ist dazu ausgebildet, das Verfahren nach einem der oben erwähnten Ansprüche durchzuführen. Das Computerprogrammprodukt ist also dazu ausgebildet, das Verfahren zur Zustandsüberwachung von mindestens einer von zwei oder mehr stromführenden elektrischen Komponenten durchzuführen. Insbesondere ist es dazu ausgebildet, den Schritt Erfassen von Messwerten einer elektrischen Größe in der gemeinsamen Stromeinspeisungsleitung vor und nach einem Schaltvorgang in einer oder mehrerer der Stromzuführungsleitungen durchzuführen. Außerdem ist es dazu ausgebildet, den Schritt Berechnen einer Differenz zwischen einem vor dem Schaltvorgang erfassten Messwert und einem nach dem Schaltvorgang erfassten Messwert auszuführen. Des weiteres ist es dazu ausgebildet, den Schritt Ermitteln einer Zustandsveränderung mindestens einer der zwei oder mehr Komponenten auf Basis einer Zeitreihe von Differenzen auszuführen. Erfindungsgemäß ist das Computerprogrammprodukt dazu ausgebildet, mindestens eine Ausführungsform des skizzierten Verfahrens zur Zustandsüberwachung umzusetzen und durchzuführen. Dabei kann das Computerprogrammprodukt sämtliche Teilfunktionen des Verfahrens in sich vereinigen, also monolithisch ausgebildet sein. Alternativ kann das Computerprogrammprodukt auch segmentiert ausgebildet sein und jeweils Teilfunktionen auf Segmente verteilen, die auf separater Hardware ausgeführt werden. So kann das Computerprogrammprodukt teilweise in einer Steuereinheit des Sensors und teilweise in einer Steuereinheit des Steuermoduls ausführbar ausgebildet sein. Außerdem kann ein Teil des Verfahrens in der Steuer- und Messeinrichtung durchgeführt werden und ein anderer Teil des Verfahrens in einer der Steuer- und Messeinrichtung übergeordneten Steuereinheit, wie beispielsweise einer SPS, einem Handparametriergerät oder einer Computer-Cloud.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: eine Stromverteilungseinrichtung;
- FIG 2: einen Stromverlauf in einer gemeinsamen Stromeinspeisungsleitung bei einem Aus- und Einschaltvorgang;
- FIG 3: einen Stromverlauf in einer gemeinsamen Stromeinspeisungsleitung für einen industriellen Schaltzyklus im Falle einer ordnungsgemäß arbeitenden Anlage;
- FIG 4: den Stromverlauf von FIG 3 im Falle eines Defekts in der Anlage;
- FIG 5: Stromverläufe in einer gemeinsamen Stromeinspeisungsleitung beim Einschalten eines Elektromotors;
- FIG 6: einen Stromverlauf in einer gemeinsamen Stromeinspeisungsleitung beim aufeinanderfolgenden Einschalten von zwei Elektromotoren;
- FIG 7: zwei veränderbare Zeitfenster zur Messung eines Stromverlaufs in einer gemeinsamen Stromeinspeisungsleitung beim Einschalten eines Elektromotors;
- FIG 8: ein Phasendiagramm;
- FIG 9: einen Ausschnitt einer Stromverteilungseinrichtung für ein 3-phasiges Drehstromnetz; und
- FIG 10: ein Ablaufdiagramm des beanspruchten Verfahrens.

Die vorliegende Erfindung betrifft - allgemein gesprochen - einen elektrotechnischen Sachverhalt. Begriffe wie "verbunden" und "getrennt" oder "isoliert" und dergleichen sind daher stets im elektrischen Sinne gemeint, nicht im mechanischen Sinne.

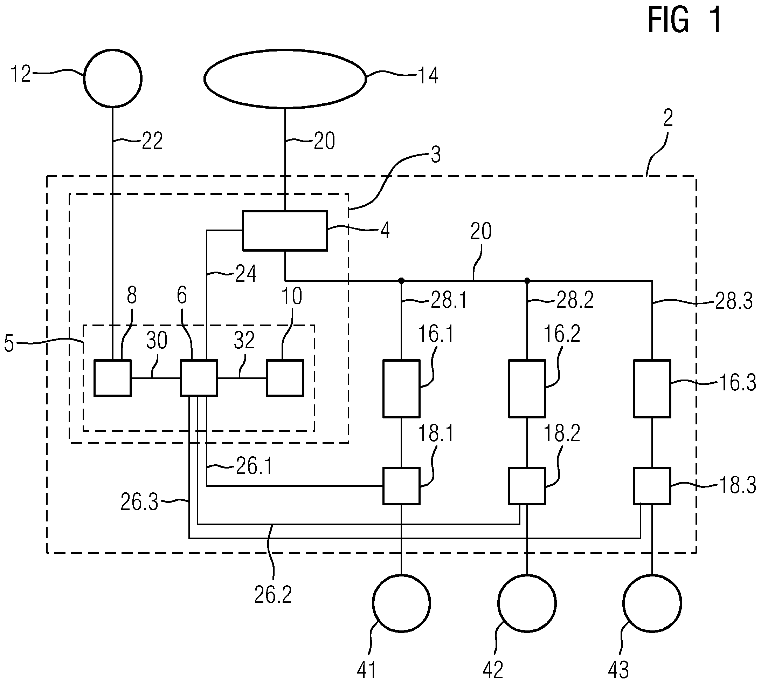

FIG 1 zeigt eine Stromverteilungseinrichtung 2, welche elektrischen Strom von einem Elektrizitätsnetz 14 zu drei Elektromotoren 41, 42, 43 als stromführende elektrische Komponenten leitet. Die drei Elektromotoren 41, 42, 43 dienen jeweils als Antriebe von nicht dargestellten Anlagen, z.B. Lüftern, Förderbändern oder Rührern. Die Stromleitung von dem Elektrizitätsnetz 14 zu der Stromverteilungseinrichtung 2 erfolgt über eine gemeinsame Stromeinspeisungsleitung 20. Die Stromverteilungseinrichtung 2 weist einen Sensor 4 zum Erfassen einer elektrischen Größe in der gemeinsame Stromeinspeisungsleitung 20 auf. Die Stromleitung von der gemeinsamen Stromeinspeisungsleitung 20 zu den drei Elektromotoren 41, 42, 43 erfolgt jeweils über eine von drei separaten Stromzuführungsleitungen 28.1, 28.2, 28.3. Die Stromverteilungseinrichtung 2 weist für jede der separaten Stromzuführungsleitungen 28.1, 28.2, 28.3 einen Leistungsschalter 16.1, 16.2, 16.3 und ein in Stromrichtung dem jeweiligen Leistungsschalter 16.1, 16.2, 16.3 nachgeschaltetes Schaltgerät 18.1, 18.2, 18.2 auf.

Die Schaltgeräte 18.1, 18.2, 18.2 dienen zum Schalten, d. h. dem Öffnen bzw. Schließen, der den Schaltgeräten 18.1, 18.2, 18.3 jeweils zugeordneten Stromzuführungsleitung 28.1, 28.2, 28.3. Die Leistungsschalter 16.1, 16.2, 16.3 dienen dem Schutz der nachgeordneten Komponenten, d. h. der Stromzuführungsleitungen 28.1, 28.2, 28.3, der Schaltgeräte 18.1, 18.2, 18.3 sowie der Elektromotoren 41, 42, 43 vor schädlichen Kurzschluss- und Überlastströmen.

Die Stromverteilungseinrichtung 2 weist außerdem eine Steuer- und Messeinrichtung 3 auf, welche einen Sensor 4 und ein Steuermodul 5 aufweist. Das Steuermodul 5 weist einen Prozessor 6 auf, durch den die Schaltgeräte 18.1, 18.2, 18.2 steuerbar sind, z. B. zum Öffnen bzw. Schließen der Stromzuführungsleitung 28.1, 28.2, 28.3 getriggert werden können. Dazu ist jedes der Schaltgeräte 18.1, 18.2, 18.3 über einen entsprechende Steuerleitung 26.1, 26.3, 26.3 mit dem Prozessor 6 verbunden. Dabei ist die Verbindung zwischen dem Prozessor 6 und jedem der Schaltgeräte 18.1, 18.2, 18.2 nicht über einen Datenbus realisiert, sondern mittels einer Direktverbindung ohne Zeitverzögerung.

Der Prozessor 6 ist außerdem über eine Sensordatenleitung 24 mit dem an der gemeinsamen Stromeinspeisungsleitung 20 angeordneten Sensor 4 verbunden. Dadurch können von dem Sensor 4 erfasste Messwerte an den Prozessor 6 übertragen werden. Dabei ist die Verbindung zwischen dem Sensor 4 und dem Prozessor 6 nicht über einen Datenbus realisiert, sondern mittels einer Direktverbindung ohne Zeitverzögerung.

Das Steuermodul 5 weist außerdem eine als ein Schnittstellenmodul ausgebildete Kommunikationsschnittstelle 8 auf, die über eine Kommunikationsverbindung 30 mit dem Prozessor 6 verbunden ist. Mittels der Kommunikationsschnittstelle 8 ist die Stromverteilungseinrichtung 2 mit einem Kommunikationsnetzwerk 12 verbindbar. Zum Beispiel kann der Prozessor 6 von dem Sensor 4 erhaltene Messwerte, gegebenenfalls nach einer Vorverarbeitung der Messwerte durch den Prozessor, z. B. zur Reduktion der Datenvolumens, über die Kommunikationsschnittstelle 8 in das Kommunikationsnetzwerk 12 senden, wo die Messwerte z. B. einer eingehenden Analyse unterzogen werden können, beispielsweise mittels automatischer prädiktiver and präskriptiver Prozesse. Das Kommunikationsnetzwerk 12 kann dazu Programme zur Analyse von Messwerten aufweisen, z. B. in Form einer cloud-basierten IoT-Plattform wie Mindsphere^{®}. Das Kommunikationsnetzwerk 12 kann auch eine übergeordnete Steuerung für die Stromverteilungseinrichtung 2 aufweisen, die auf Basis der im Kommunikationsnetzwerk 12 ablaufenden Analyse der Messwerte dem Prozessor 6 über die Datenleitung 22 Steuerbefehle übermittelt, welche vom Prozessor 6 in entsprechende Steuersignale an die Schaltgeräte 18.1, 18.2, 18.3 umgesetzt werden.

Das Steuermodul 5 weist außerdem einen Speicher 10 zur Datenspeicherung auf, der über eine Kommunikationsverbindung 32 mit dem Prozessor 6 verbunden ist. In dem Speicher 10 können Messwerte, die vom Sensor 4 an den Prozessor 6 übertragen werden, zwischengespeichert werden, z. B. bis ein geeigneter Zeitpunkt zur Übertragung der Messwerte von der Stromverteilungseinrichtung 2 in das Kommunikationsnetzwerk 12 gekommen ist.

Ein Computerprogrammprodukt zur Ausführung des Verfahrens zur Zustandsüberwachung von mindestens einer von zwei oder mehr stromführenden elektrischen Komponenten ist in dem Speicher 10 abgelegt und wird in dem Prozessor 6 der Steuer- und Messeinrichtung 3 ausgeführt. Wenn das Computerprogrammprodukt im Prozessor 6 abläuft, werden die Schritte Erfassen von Messwerten einer elektrischen Größe in der gemeinsamen Stromeinspeisungsleitung 20 vor und nach einem Schaltvorgang in einer oder mehrerer der Stromzuführungsleitungen 28.1, 28.2, 28.3); Berechnen einer Differenz zwischen einem vor dem Schaltvorgang erfassten Messwert und einem nach dem Schaltvorgang erfassten Messwert; und Ermitteln einer Zustandsveränderung mindestens einer der zwei oder mehr Komponenten 18.1, 18.2, 18.3, 41, 42, 43 auf Basis einer Zeitreihe von Differenzen durchgeführt.

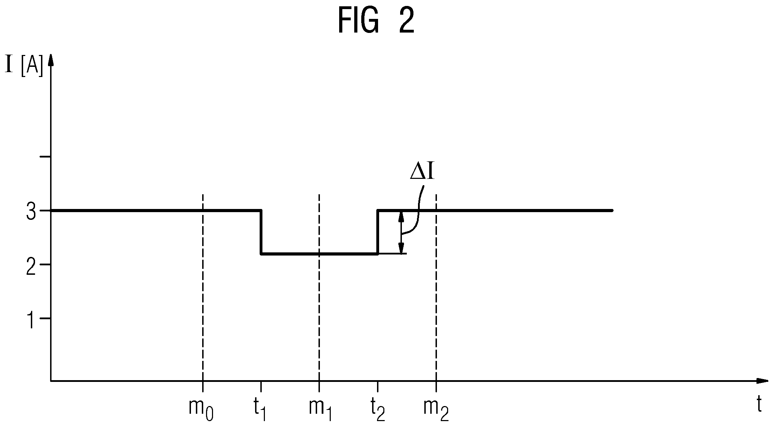

FIG 2 zeigt einen zeitlichen Verlauf der in einer gemeinsamen Stromeinspeisungsleitung 20 gemessenen Stromstärke I in der Einheit Ampere. Zu den Zeitpunkten m0, m1 und m2 erfasst der Sensor 4 Messwerte der Stromstärke. Zum Zeitpunkt t1 wird eine der drei Stromzuführungsleitungen 28.1, 28.2, 28.3 geöffnet, d. h. stromsperrend geschaltet, wodurch die Stromstärke I in der gemeinsamen Stromeinspeisungsleitung 20 um einen Betrag ΔI absinkt. Zum Zeitpunkt t2 wird die eine geöffnete Stromzuführungsleitung 28.1, 28.2, 28.3 wieder geschlossen, d. h. stromleitend geschaltet, wonach die Stromstärke I in der Stromeinspeisungsleitung 20 wieder auf ihren ursprünglichen Wert ansteigt. Dieses Beispiel eines Schaltvorgangs illustriert das erfindungsgemäße Verfahren: ein Unterbrechen bzw. Wiederherstellen des Stromflusses in einer oder mehrerer der Stromzuführungsleitungen 28.1, 28.2, 28.3 führt zu einer Änderung einer elektrischen Größe, hier: der Stromstärke, in der gemeinsamen Stromeinspeisungsleitung 20, welche, erfasst und ausgewertet, Rückschlüsse auf den Stromverlauf in den einzelnen Stromzuführungsleitungen 28.1, 28.2, 28.3 und somit auf den Zustand von stromführenden elektrischen Komponenten erlaubt, welche über die Stromzuführungsleitungen 28.1, 28.2, 28.3 mit elektrischer Energie versorgt werden.

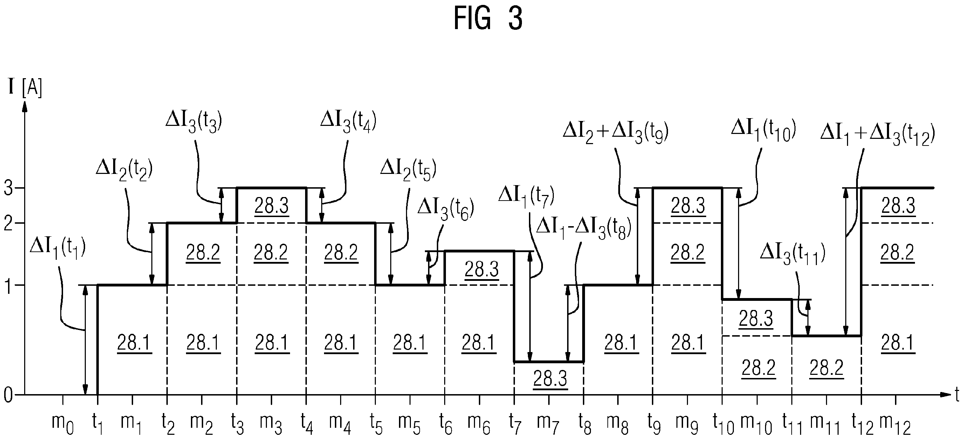

FIG 3 zeigt einen zeitlichen Verlauf der in der gemeinsamen Stromeinspeisungsleitung 20 der in FIG 1 dargestellten Stromverteilungseinrichtung 2 gemessenen Stromstärke I in einer beliebigen Einheit für einen industriellen Schaltzyklus im Falle einer ordnungsgemäß arbeitenden Anlage, umfassend drei Elektromotoren 41, 42, 43 mit unterschiedlicher Leistung. Beispielsweise treiben die drei Elektromotoren 41, 42, 43 unterschiedlich lange Förderbänder einer Förderanlage an, wobei der durch eine Steuerung vorgegebene Schaltzyklus eine ordnungsgemäße Förderung von Gütern durch die Förderanlage sicherstellt. Zu den Zeitpunkten m0 bis m12 erfasst der Sensor 4 jeweils Messwerte der Stromstärke in der gemeinsamen Stromeinspeisungsleitung 20.

Zum Zeitpunkt t1 wird eine den ersten Elektromotor 41 mit elektrischer Energie versorgende erste Stromzuführungsleitung 28.1 durch Schließen der Kontakte des ersten Schaltgeräts 18.1 stromleitend geschaltet, d. h. geschlossen, wodurch die Stromstärke I in der gemeinsamen Stromeinspeisungsleitung 20 um einen Betrag ΔI1(t1) ansteigt. Es ist zu beachten, dass ΔIₓ(ty) eine vereinfachte Schreibweise für ΔI_{28.x}(ty) ist, wobei diese vereinfachte Schreibweise für alle in dieser Beschreibung auftretenden Stromdifferenzwerte verwendet wird. Zum Zeitpunkt t2 wird zusätzlich eine den zweiten Elektromotor 42 mit elektrischer Energie versorgende zweite Stromzuführungsleitung 28.2 durch Schließen der Kontakte des zweiten Schaltgeräts 18.2 stromleitend geschaltet, d. h. geschlossen, wodurch die Stromstärke I in der gemeinsamen Stromeinspeisungsleitung 20 um einen Betrag ΔI2(t2) ansteigt. Zum Zeitpunkt t3 wird zusätzlich eine den dritten Elektromotor 43 mit elektrischer Energie versorgende dritte Stromzuführungsleitung 28.3 durch Schließen der Kontakte des dritten Schaltgeräts 18.3 stromleitend geschaltet, d. h. geschlossen, wodurch die Stromstärke I in der gemeinsamen Stromeinspeisungsleitung 20 um einen Betrag ΔI3(t3) ansteigt. Zum Messzeitpunkt m3 liegt die vom Sensor 4 erfasste Stromstärke I in der gemeinsamen Stromeinspeisungsleitung 20 also bei einem Wert, welcher der Summe ΔI1(t1) + ΔI2(t2) + ΔI3(t3) entspricht.

Zum Zeitpunkt t4 wird die dritte Stromzuführungsleitung 28.3 durch Öffnen der Kontakte des dritten Schaltgeräts 18.3 stromsperrend geschaltet, d. h. geöffnet, wodurch die Stromstärke I in der gemeinsamen Stromeinspeisungsleitung 20 um einen Betrag ΔI3(t4) absinkt. Zum Zeitpunkt t5 wird die zweite Stromzuführungsleitung 28.2 durch Öffnen der Kontakte des zweiten Schaltgeräts 18.2 stromsperrend geschaltet, d. h. geöffnet, wodurch die Stromstärke I in der gemeinsamen Stromeinspeisungsleitung 20 um einen Betrag ΔI2(t5) absinkt. Zum Zeitpunkt t6 wird die dritte Stromzuführungsleitung 28.3 durch Schließen der Kontakte des dritten Schaltgeräts 18.3 stromleitend geschaltet, d. h. geschlossen, wodurch die Stromstärke I in der gemeinsamen Stromeinspeisungsleitung 20 um einen Betrag ΔI3(t6) ansteigt.

Zum Zeitpunkt t7 wird die erste Stromzuführungsleitung 28.1 durch Öffnen der Kontakte des ersten Schaltgeräts 18.1 stromsperrend geschaltet, d. h. geöffnet, wodurch die Stromstärke I in der gemeinsamen Stromeinspeisungsleitung 20 um einen Betrag ΔI1(t7) absinkt, auf einen Wert, der dem Stromfluss in der dritten Stromzuführungsleitung 28.3 entspricht.

Zum Zeitpunkt t8 wird die dritte Stromzuführungsleitung 28.3 durch Öffnen der Kontakte des dritten Schaltgeräts 18.3 stromsperrend geschaltet, d. h. geöffnet, und gleichzeitig die erste Stromzuführungsleitung 28.1 durch Schließen der Kontakte des ersten Schaltgeräts 18.1 stromleitend geschaltet, d. h. geschlossen, wodurch die Stromstärke I in der gemeinsamen Stromeinspeisungsleitung 20 um einen Betrag ΔI1-ΔI3(t7) ansteigt, auf einen Wert, der dem Stromfluss in der ersten Stromzuführungsleitung 28.1 entspricht.

Zum Zeitpunkt t9 wird die zweite Stromzuführungsleitung 28.2 durch Schließen der Kontakte des zweiten Schaltgeräts 18.2 stromleitend geschaltet, d. h. geschlossen, und gleichzeitig die dritte Stromzuführungsleitung 28.3 durch Schließen der Kontakte des dritten Schaltgeräts 18.3 stromleitend geschaltet, d. h. geschlossen, wodurch die Stromstärke I in der gemeinsamen Stromeinspeisungsleitung 20 um einen Betrag ΔI2+ ΔI3(t9) ansteigt.

Zum Zeitpunkt t10 wird die erste Stromzuführungsleitung 28.1 durch Öffnen der Kontakte des ersten Schaltgeräts 18.1 stromsperrend geschaltet, d. h. geöffnet, wodurch die Stromstärke I in der gemeinsamen Stromeinspeisungsleitung 20 um einen Betrag ΔI1(t10) absinkt, auf einen Wert, der der Summe der Stromflüsse in der zweiten Stromzuführungsleitung 28.2 und der dritten Stromzuführungsleitung 28.3 entspricht.

Zum Zeitpunkt t11 wird die dritte Stromzuführungsleitung 28.3 durch Öffnen der Kontakte des dritten Schaltgeräts 18.3 stromsperrend geschaltet, d. h. geöffnet, wodurch die Stromstärke I in der gemeinsamen Stromeinspeisungsleitung 20 um einen Betrag ΔI3(t11) absinkt.

Zum Zeitpunkt t12 wird die erste Stromzuführungsleitung 28.1 durch Schließen der Kontakte des ersten Schaltgeräts 18.1 und die gleichzeitig die dritte Stromzuführungsleitung 28.3 durch Schließen der Kontakte des dritten Schaltgeräts 18.3 stromleitend geschaltet, d. h. geschlossen, wodurch die Stromstärke I in der gemeinsamen Stromeinspeisungsleitung 20 um einen Betrag ΔI1+ΔI3(t12) ansteigt.

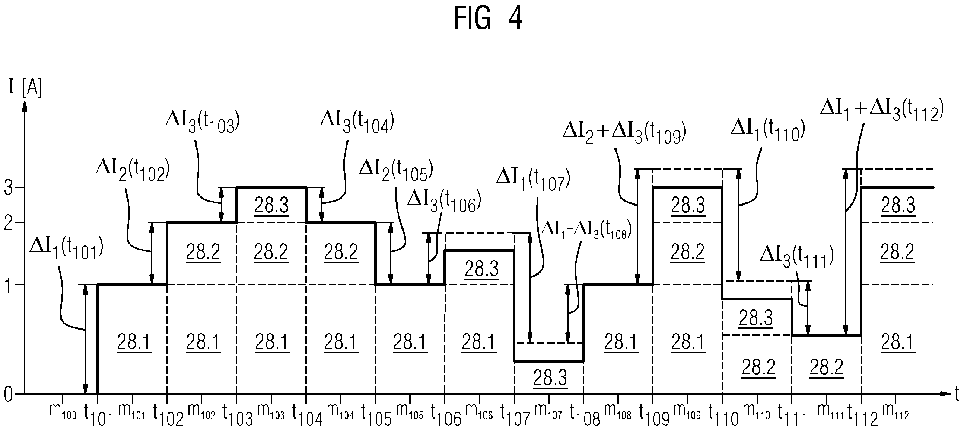

FIG 4 zeigt den Stromverlauf von FIG 3, wobei ab dem Zeitpunkt m106, wie aus dem Zustand bzw. dem Verhalten des dritten Elektromotors 43 erkennbar, ein Defekt in der Anlage vorliegt. Während zum Zeitpunkt m103 auf Basis der Stromstärke in der dritten Stromzuführungsleitung 28.3 noch keine Zustandsänderung des dritten Elektromotors 43 erkennbar ist, ist zu den darauffolgenden Messzeitpunkten m106 und m111, vor denen der dritte Elektromotors 43 ein- oder ausgeschaltet wurde, eine im Vergleich zu dem Zeitpunkt m103 erhöhte Stromstärke in der zum dritten Elektromotor 43 führenden dritten Stromzuführungsleitung 28.3 aus den in der gemeinsamen Stromeinspeisungsleitung 20 gewonnenen Messwerten ableitbar: ΔI3(t106) > ΔI3(t103) und ΔI3(t111) > ΔI3(t103). Daraus kann geschlossen werden, dass der dritte Elektromotor 43 gegen eine erhöhte Last arbeiten muss, z. B. aufgrund einer Verklemmung in dem von dem Elektromotor 43 angetriebenen Förderband.

Alternativ können auch die Messungen nach den Schaltzeitpunkten t107 und t108 ausgewertet werden: aus ΔI1(t107) = ΔI1(t101) und ΔI1-ΔI3(t108) ≠ ΔI1(t101) - ΔI3(t103) folgt, dass der dritte Elektromotor 43 gegen eine erhöhte Last arbeiten muss, d. h. dass in dem über die dritten Stromzuführungsleitung 28.3 versorgten Abzweig ein Defekt vorliegt.

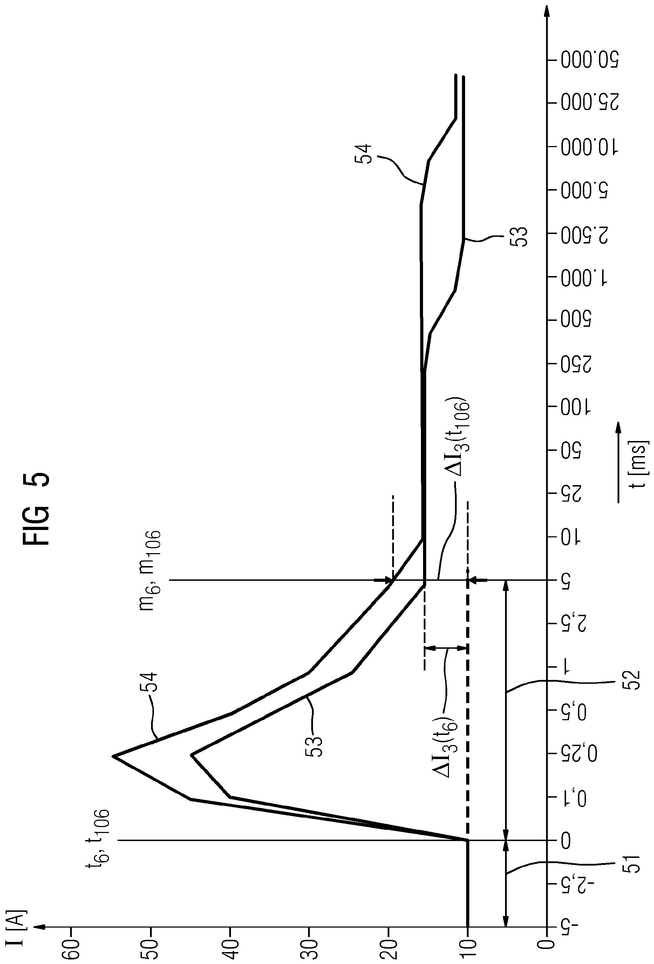

FIG 5 zeigt, in großem Detail, einen Stromverlauf 53 in der gemeinsamen Stromeinspeisungsleitung 20 beim Einschalten des dritten Elektromotors 43 zum Zeitpunkt t6, wie in FIG 3 dargestellt, und einen Stromverlauf 54 in der gemeinsamen Stromeinspeisungsleitung 20 beim Einschalten des dritten Elektromotors 43 zum Zeitpunkt t106, wie in FIG 4 dargestellt, als Auftragung der Stromstärke I in der Einheit Ampere über der Zeit t in der Einheit Millisekunden. Der Nullpunkt der Zeitachse t liegt bei den Einschaltzeitpunkten t6, t106, wobei die Auftragung der Zeitwerte links von dem Nullpunkt linear ist, wohingegen die Auftragung der Zeitwerte rechts von dem Nullpunkt, zur genaueren Darstellung der Stromverläufe 53, 54, in logarithmischem Maßstab ist. Die Stromverläufe 53, 54 bilden den "Footprint" des dritten Elektromotors 43, wobei der niedrigere Stromverlauf 53 des Elektromotors 43 zu einem früheren Zeitpunkt, z. B. während eines vor der Auslieferung an einen Betreiber des Elektromotors 43 durch den Hersteller durchgeführten Funktionstest des Elektromotors 43 oder unmittelbar nach dessen Inbetriebnahme bei einem Betreiber des Elektromotors 43, aufgenommen wurde und der höhere Stromverlauf 54 des Elektromotors 43 zu einem späteren Zeitpunkt aufgenommen wurde, bei dem eine deutlich erkennbare Störung vorliegt. Da zu den Zeitpunkten t6, t106 der dritte Elektromotor 43 zusätzlich zu dem bereits laufenden ersten Elektromotor 41 eingeschaltet wird, addiert sich in der gemeinsamen Stromeinspeisungsleitung 20 die Stromwert in der dritten Stromzuführungsleitung 28.3 zu der Stromstärke von ca. 10 Ampere in der ersten Stromzuführungsleitung 28.1.

Vor den Schaltzeitpunkten t6, t106 ist ein erstes, 5 ms langes Zeitfenster 51 definiert, in dem der Sensor 4 in hoher Frequenz, z. B. 10.000 Hz, Messwerte an der gemeinsamen Stromeinspeisungsleitung 20 erfasst. Außerdem ist nach den Schaltzeitpunkten t6, t106 ein zweites, 5 ms langes Zeitfenster 52 definiert, in dem der Sensor 4 in hoher Frequenz, z. B. 10.000 Hz, Messwerte an der gemeinsamen Stromeinspeisungsleitung 20 erfasst.

Bei beiden Stromverläufen 53, 54 fließt unmittelbar nach dem Schließen der Schaltkontakte des dritten Schaltgeräts 18.3 ein Einschaltstrom, der sogenannte "Einschaltrush", der ein Vielfaches des sich im Dauerbetrieb einstellenden Nennstroms des Elektromotors beträgt. Das zweite Zeitfenster 52 deckt im Wesentlichen den gesamten Verlauf des Einschaltstroms ab. Es ist deutlich zu erkennen, dass der Einschaltstrom im gestörten Zustand im gesamten zweiten Zeitfenster 52 höhere Werte erreicht als der Einschaltstrom im ursprünglichen Zustand. Im zweiten Zeitfenster 52 erfasst der Sensor 4 mit einer Periode von z. B. 0,1 ms Messwerte an der gemeinsamen Stromeinspeisungsleitung 20.

Am Ende des zweiten Zeitfensters 52 sind in FIG 5 die Differenzen ΔI3(t6) bzw. ΔI3(t106) zwischen jeweils einem vor dem Schließen erfassten Strommesswert und einem nach dem Schlie-ßen, zu den Messzeitpunkten m6 bzw. m106 erfassten Strommesswert angegeben. Die beiden Differenzen ΔI3(t6) und ΔI3(t106) bilden eine Zeitreihe von Differenzen, aus der der erhöhte Einschaltstrom zum Zeitpunkt t106 erkennbar ist, was als ein Hinweis auf eine Verschlechterung des Zustands des Elektromotors dient.

Die Differenzen ΔIx(ty) können entweder als ein Messwert zu einem Messzeitpunkt oder als ein Integral aller in einem Zeitfenster bisher erfasster Messwerte berechnet werden.

Nach dem Einschaltstrom folgt eine Hochlaufphase des Elektromotors, bis der Elektromotor seine Nenndrehzahl erreicht hat und die Stromstärke auf den Nennstrom im Dauerbetrieb absinkt. Die Stromstärke in der Hochlaufphase ist in beiden Zuständen des Elektromotors ungefähr gleich (ca. 6 A), der Elektromotor benötigt im gestörten Zustand aber signifikant länger als im ungestörten Zustand, bis er seine Nenndrehzahl erreicht hat: ca. 5000 ms gegenüber ca. 250 ms. Auch der Nennstrom ist in beiden Zuständen des Elektromotors unterschiedlich; der Nennstrom des Elektromotors liegt im gestörten Zustand signifikant höher als im ungestörten Zustand: ca. 2 A gegenüber ca. 1 A. Die Gesamtheit der Unterschiede bildet die Änderung des "Footprint" des Elektromotors. Zeitliche Änderungen der Differenzen der zu unterschiedlichen Zeitpunkten gemessenen Stromstärken dienen als Hinweis auf eine Verschlechterung des Zustands des Elektromotors.

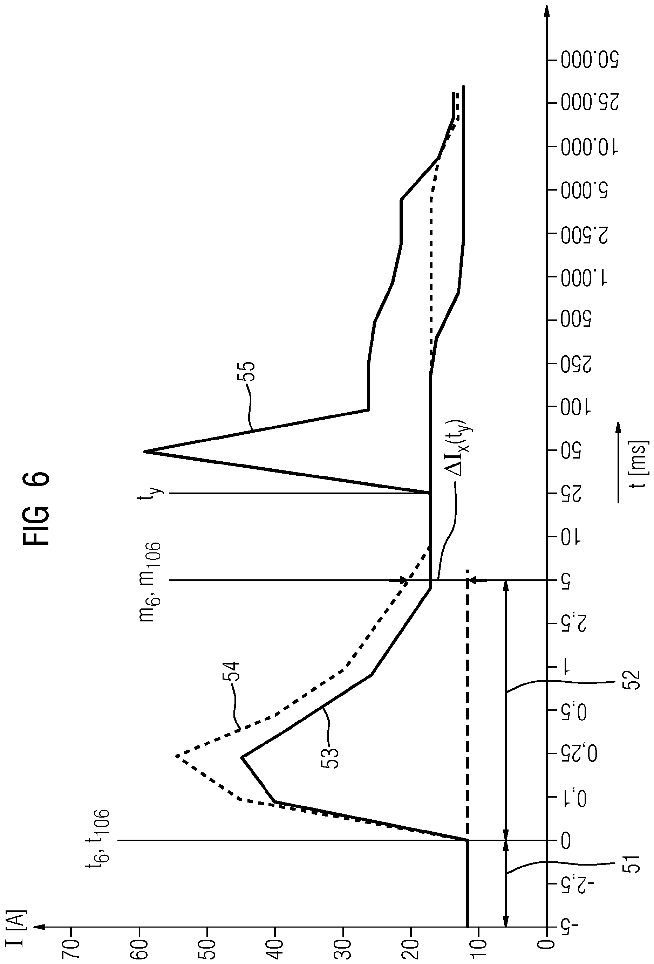

FIG 6 basiert auf FIG 5, zeigt aber zusätzlich noch einen dritten Stromverlauf 55 in der gemeinsamen Stromeinspeisungsleitung 20, der vom Einschalten des zweiten Elektromotors 42 zu einem dem Zeitpunkt t6 bzw. t106 nachfolgenden Zeitpunkt ty = 25 ms stammt. Um die Messung des Stromverlaufs 53, 54 des Einschaltstroms des dritten Elektromotors 43 nicht zu verfälschen, wird mit dem Einschalten des zweiten Elektromotors 42 so lange gewartet, bis der Einschaltstrom des dritten Elektromotors 43 ab t = 10 ms in das Hochlaufplateau übergegangen ist. Durch den Zeitversatz von 25 ms zwischen dem Einschalt-Zeitpunkt t6, t106 und dem Einschalt-Zeitpunkt ty überlappen die Stromverläufe der Einschaltströme 53, 54 und der Stromverlauf des Einschaltstroms 55 nicht. Der Zeitversatz von 25 ms ist ausreichend groß, so dass eine eindeutige Zuordenbarkeit von gemessenen Stromwerten zu einem der Elektromotoren 42, 43 sichergestellt ist. Der Zeitversatz von 25 ms ist andererseits ausreichend klein, so dass die Einschaltzeitpunkte im realen Betrieb als praktisch gleichzeitig wahrgenommen werden. Mit anderen Worten: das erfindungsgemäße Verfahren kann durchgeführt werden, ohne einen Betrieb einer Anlage zu stören.

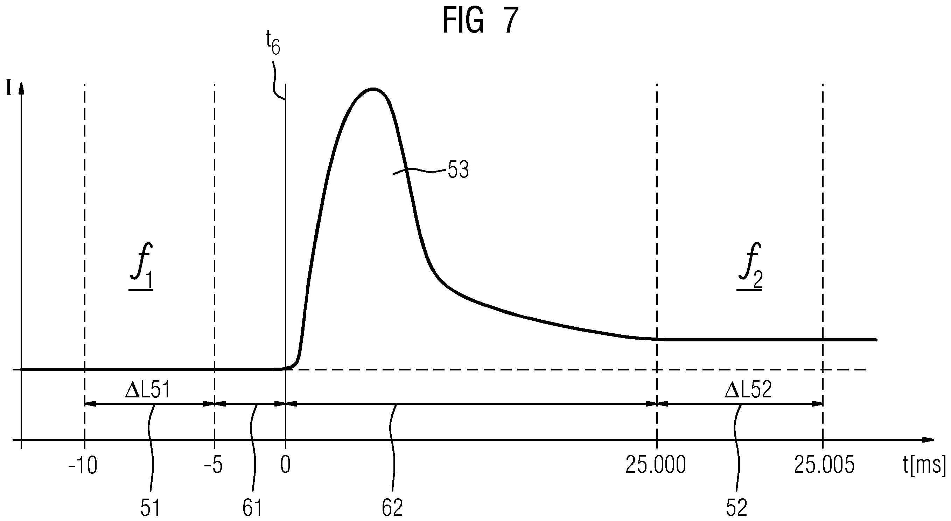

FIG 7 zeigt zwei veränderbare Zeitfenster 51, 52 zur Messung eines Stromverlaufs 53, durch den in FIG 1 dargestellten Sensor 4 in der in FIG 1 dargestellten gemeinsamen Stromeinspeisungsleitung 20, beim Einschalten eines Elektromotors zum Zeitpunkt t6, als Auftragung der Stromstärke I über der Zeit t in der Einheit Millisekunden. Der Nullpunkt der Zeitachse t liegt beim Einschaltzeitpunkt t6, wobei die Auftragung der Zeitwerte links von dem Nullpunkt linear ist, wohingegen die Auftragung der Zeitwerte rechts von dem Nullpunkt, zur genaueren Darstellung des Stromverlaufs 53, in logarithmischem Maßstab ist.

Vor dem Schaltzeitpunkt t6 ist ein erstes Zeitfenster 51 mit der Länge ΔL51 und einem zeitlichen Abstand 61 vom Schaltzeitpunkt t6 definiert. Innerhalb des erstes Zeitfensters 51, welches eine Länge ΔL51 von 5 ms aufweist, erfasst ein Sensor 4 mit einer ersten Frequenz f1, z. B. 1000 Hz, Messwerte an der gemeinsamen Stromeinspeisungsleitung 20. Nach dem Schaltzeitpunkt t6 ist ein zweites Zeitfenster 52 mit der Länge ΔL52 und einem zeitlichen Abstand 62 vom Schaltzeitpunkt t6 definiert. Innerhalb des zweiten Zeitfensters 52, welches eine Länge ΔL52 von 5 ms aufweist, erfasst der Sensor 4 mit einer zweiten Frequenz f2, z. B. 10.000 Hz, Messwerte an der gemeinsamen Stromeinspeisungsleitung 20.

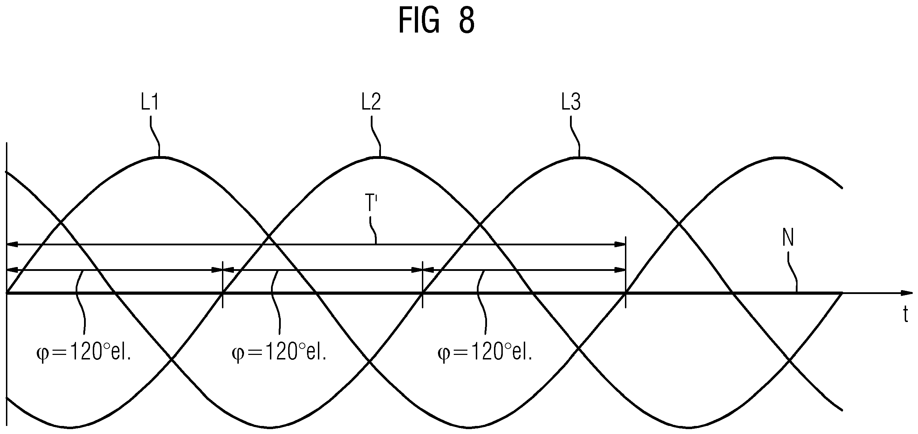

FIG 8 zeigt eine Darstellung eines Spannungsverlaufs über der Zeit in einem dreiphasigen Drehstromnetz, welches außer den drei Phasen L1, L2, L3 noch einen Neutralleiter N aufweist.

FIG 8 zeigt die Spannungsverläufe der Phasen L1-L3 gegenüber dem Neutralleiter N über der Zeit t. Gemäß FIG 8 weisen die Phasen L1-L3 relativ zueinander einen Phasenversatz ϕ von +/-120 ° elektrisch auf, wobei T' die Periode des Drehstromnetzes ist. Der Phasenversatz ϕ der Phase L3 zur Phase L2, der Phase L2 zur Phase L1 und der Phase L1 zur Phase L3 beträgt +120 ° elektrisch. Der Phasenversatz ϕ der Phase L3 zur Phase L1, der Phase L1 zur Phase L2 und der Phase L2 zur Phase L3 beträgt -120 ° oder +240 ° elektrisch. Da die Phasen L1-L3 nur modulo 360 ° elektrisch bestimmt sind, ist der Phasenversatz ϕ der Phase L3 zur Phase L1, der Phase L1 zur Phase L2 und der Phase L2 zur Phase L3 auch als +240 ° elektrisch ausdrückbar.

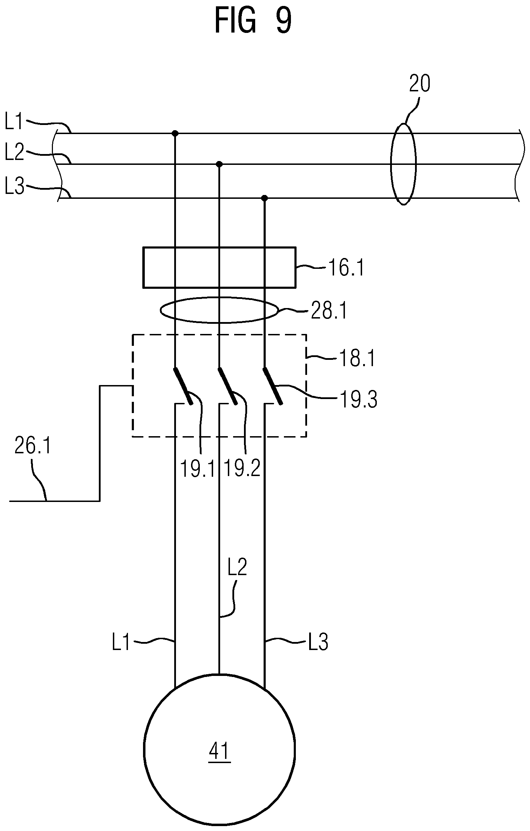

FIG 9 zeigt einen vergrößerten Ausschnitt aus FIG 1, wobei die Stromverteilungseinrichtung 2 für ein 3-phasiges Drehstromnetz ausgestaltet ist und die Stromeinspeisungsleitung 20 und die Stromzuführungsleitung 28.1 als 3-Phasen-Leiter ausgebildet sind.

Gemäß FIG 9 ist das elektromagnetische Schaltgerät 18.1 als Schütz ausgebildet. Es weist eine Kontaktanordnung mit drei Kontakten 19.1, 19.2, 19.3 auf. Über die Kontakte 19.1, 19.2, 19.3 ist der als Drehstromlast wirkende Elektromotor 41 an drei Phasen L1-L3 eines Drehstromnetzes ankoppelbar bzw. von den drei Phasen L1-L3 abkoppelbar, wenn das Schaltgerät 18.1 betätigt wird. Beim Betätigen der Kontaktanordnung, also dem Öffnen bzw. Schließen der Kontakte 19.1, 19.2, 19.3, treten an den Kontakten 19.1, 19.2, 19.3 pro Schaltvorgang Schaltabbrände auf.

Gemäß der vorgenannten DE102005043895B4 besteht eine Möglichkeit zur Vergleichmäßigung der Schaltabbrände der Kontakte 19.1, 19.2, 19.3 darin, nach Erhalt eines Steuersignals über die Steuerleitung 26.1 einen Zeitpunkt abzuwarten, bei dem eine vorgegebenen Phasenlage der Versorgungsspannung erreicht wird, und wobei ab diesem Zeitpunkt eine Verzögerungszeit bis zur Betätigung des Antriebs zum Öffnen bzw. Schließen der Kontakte 19.1, 19.2, 19.3 abgewartet wird.

Gemäß der vorgenannten DE19948551C1 besteht eine andere Möglichkeit zur Vergleichmäßigung von Gesamtabbränden der Kontaktanordnung des elektromagnetischen Schaltgeräts 18.1 mit mehreren Kontakten 19.1-3 darin, dass für jeden Kontakt 19.1-3 der jeweilige Gesamtabbrand ermittelt wird, dass die Gesamtabbrände dem Prozessor 6 als Ansteuerschaltung zugeführt werden und dass die Kontaktanordnung von dem Prozessor 6 über die Steuerleitung 26.1 in Abhängigkeit von den ermittelten Gesamtabbränden derart betätigt wird, dass die Gesamtabbrände der Kontakte 19.1-3 einander angenähert werden.

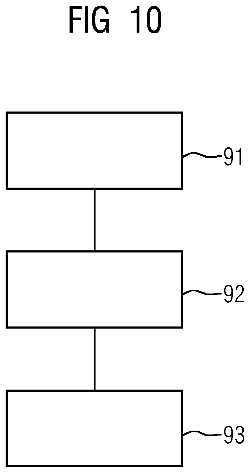

FIG 10 zeigt ein Ablaufdiagramm des beanspruchten Verfahrens. Das Verfahren umfasst einen ersten Verfahrensschritt 91, in dem Messwerte mindestens einer elektrischen Größe in der gemeinsamen Stromeinspeisungsleitung 20 vor und nach dem Öffnen bzw. Schließen einer Stromzuführungsleitung 28.1, 28.2, 28.3 erfasst werden. Dazu kann ein an der gemeinsamen Stromeinspeisungsleitung 20 angeordneter Sensor 4 der Steuer- und Messeinrichtung 3, z. B. ein Stromwandler oder ein Strommesswiderstand, Messwerte einer elektrischen Größe, z. B. eine Stromstärke oder eine Spannungsdifferenz, erfassen, welche in der gemeinsamen Stromeinspeisungsleitung 20 vor und nach dem Öffnen bzw. Schließen einer oder mehrerer der Stromzuführungsleitungen 28.1, 28.2, 28.3 auftreten.

Das Verfahren umfasst einen dem ersten Verfahrensschritt 91 nachfolgenden zweiten Verfahrensschritt 92, in dem eine Differenz zwischen einem vor dem Öffnen bzw. Schließen erfassten Messwert und einem nach dem Öffnen bzw. Schließen erfassten Messwert berechnet wird. Dazu kann der Prozessor 6 der Steuer- und Messeinrichtung 3 vom Sensor 4 erfasste Messwerte, d. h. einen vor dem Öffnen bzw. Schließen erfassten Messwert und einen nach dem Öffnen bzw. Schließen erfassten Messwert, empfangen und daraus eine Differenz zwischen dem vor dem Öffnen bzw. Schließen erfassten Messwert und dem nach dem Öffnen bzw. Schließen erfassten Messwert berechnen.

Das Verfahren umfasst einen dem zweiten Verfahrensschritt 92 nachfolgenden dritten Verfahrensschritt 93, in dem eine Zustandsveränderung mindestens einer der zwei oder mehr stromführenden elektrischen Komponenten 41, 42, 43 auf Basis einer Zeitreihe von Differenzen ermittelt wird. Dazu kann der Prozessor 6 der Steuer- und Messeinrichtung 3 eine einem ersten Zeitpunkt t1 zugeordnete Differenz ΔI(t1) mit mindestens einer einem von dem ersten Zeitpunkt t1 abweichenden zweiten t2, dritten t3, usw. Zeitpunkt zugeordneten Differenz vergleichen und daraus eine Veränderung eines Zustands mindestens einer der zwei oder mehr stromführenden elektrischen Komponenten ableiten 41, 42, 43.

Durch Auswertung dieser Messwerte im Prozessor 6, d. h. einen Vergleich der Stromwerte zu unterschiedlichen Zeitpunkten wird ermittelt, dass sich der Stromfluss in der dritten Stromzuführungsleitung 28.3 erhöht hat, was auf einen möglichen Fehler in der Anlagenkomponente 43, die über die dritten Stromzuführungsleitung 28.3 mit Strom versorgt wird, hindeutet. Ein Betreiber der Anlagenkomponente 43 kann somit eine technische Kontrolle bzw. Wartung veranlassen.

## Patentansprüche

1. Verfahren zur Zustandsüberwachung von mindestens einer von zwei oder mehr stromführenden elektrischen Komponenten (18.1, 18.2, 18.3, 41, 42, 43), welchen elektrische Energie von einer elektrischen Energiequelle (14) über eine gemeinsame Stromeinspeisungsleitung (20) und von der gemeinsamen Stromeinspeisungsleitung (20) jeweils über eine separate Stromzuführungsleitung (28.1, 28.2, 28.3), die durch einen Schaltvorgang individuell geöffnet bzw. geschlossen werden kann, zugeführt werden kann, mit folgenden Schritten:
- Erfassen von Messwerten einer elektrischen Größe in der gemeinsamen Stromeinspeisungsleitung (20) vor und nach einem Schaltvorgang in einer oder mehrerer der Stromzuführungsleitungen (28.1, 28.2, 28.3);
**gekennzeichnet durch** die folgenden Schritte:
- Berechnen einer Differenz zwischen einem vor dem Schaltvorgang erfassten Messwert und einem nach dem Schaltvorgang erfassten Messwert; und
- Ermitteln einer Zustandsveränderung mindestens einer der zwei oder mehr Komponenten (18.1, 18.2, 18.3, 41, 42, 43) auf Basis einer Zeitreihe der Differenzen
, wobei die Messwerte in einem ersten Zeitfenster (51) vor und in einem zweiten Zeitfenster (52) nach dem Schaltvorgang in der einen oder mehreren Stromzuführungsleitungen (28.1, 28.2, 28.3) erfasst werden, wobei Parameter der Zeitfenster (51, 52), insbesondere die Länge der Zeitfenster (51, 52) und der zeitliche Abstand der Zeitfenster (51, 52) zu einem Zeitpunkt (t6, t106) des Schaltvorgangs, einstellbar sind.

2. Verfahren nach Anspruch 1, wobei die Einstellung der Parameter der Zeitfenster (51, 52) abhängig davon gewählt wird, in welcher Applikation die zwei oder mehr stromführenden elektrischen Komponenten (18.1, 18.2, 18.3, 41, 42, 43) betrieben werden.

3. Verfahren nach Anspruch 2, wobei die Parameter der Zeitfenster (51, 52) applikationsabhängig in einem Speicher (10) hinterlegt sind.

4. Verfahren nach einem der vorhergehenden Ansprüche, wobei ein Schaltvorgang in einer ersten Stromzuführungsleitung (28.1, 28.2, 28.3) mit einer Verzögerung zu einem Schaltvorgang in einer zweiten Stromzuführungsleitung (28.1, 28.2, 28.3) erfolgt, insbesondere mit einer Verzögerung im Bereich von 10 bis 1000 ms.

5. Verfahren nach einem der vorhergehenden Ansprüche, wobei die Messwerte mittels mindestens eines Sensors (4) erfasst werden und eine Übertragung der erfassten Messwerte von dem Sensor (4) zu einem Prozessor (6) zur Weiterverarbeitung der Messwerte über eine ungetaktete direkte Kommunikationsverbindung (24) erfolgt.

6. Verfahren nach einem der vorhergehenden Ansprüche, wobei eine Übertragung von Steuersignalen zum Schalten einer Stromzuführungsleitung (28.1, 28.2, 28.3) von einem die Steuersignale generierenden Prozessor (6) zu der Stromzuführungsleitung (28.1, 28.2, 28.3) über eine ungetaktete direkte Kommunikationsverbindung (26.1, 26.2, 26.3) erfolgt.

7. Verfahren nach einem der vorhergehenden Ansprüche, wobei erfasste Messwerte über eine Schnittstelleneinheit (8) in ein Kommunikationsnetzwerk (12) übertragen werden.

8. Verfahren nach einem der vorhergehenden Ansprüche, wobei ein Motorverschleiß auf Basis eines Einschaltrush, ein Kontaktverschleiß auf Basis eines Stromverlaufs, oder ein Verschleiß einer elektromotorisch betriebenen Applikation auf Basis einer Hochlaufkurve eines antreibenden Elektromotors (41, 42, 43) ermittelt wird.

9. Verfahren nach einem der vorhergehenden Ansprüche, wobei bei einem mehrphasigen Wechselstrom durch ein Auswerten der Stromstärke in den jeweiligen Stromphasen (L1, L2, L3) der Stromzuführungsleitungen (28.1, 28.2, 28.3) ein Synchronisationseffekt erkannt und in Reaktion darauf der Schaltverzug zwischen den Stromphasen (L1, L2, L3) so verändert wird, dass die Kontakte (19.1, 19.2, 19.3) eines Schaltgeräts (18.1, 18.2, 18.3), welches das Schalten der Stromphasen (L1, L2, L3) ausführt, gleichmäßig verschleißen.

10. Steuer- und Messeinrichtung (3), aufweisend
- einen Sensor (4) zum Erfassen von Messwerten einer elektrischen Größe in einer Stromeinspeisungsleitung (20) vor und nach einem Schaltvorgang in einer oder mehrerer Stromzuführungsleitungen (28.1, 28.2, 28.3), wobei elektrischer Strom von einer elektrischen Energiequelle (14) über die gemeinsame Stromeinspeisungsleitung (20) und von der gemeinsamen Stromeinspeisungsleitung (20) jeweils über eine separate Stromzuführungsleitung (28.1, 28.2, 28.3), die durch den Schaltvorgang individuell geöffnet bzw. geschlossen werden kann, zu zwei oder mehr stromführenden elektrischen Komponenten (18.1, 18.2, 18.3, 41, 42, 43) geführt wird; und
**gekennzeichnet durch**:
- einen Prozessor (6) zum Berechnen einer Differenz zwischen einem vor dem Schaltvorgang erfassten Messwert und einem nach dem Schaltvorgang erfassten Messwert und zum Ermitteln einer Zustandsveränderung mindestens einer der zwei oder mehr Komponenten (18.1, 18.2, 18.3, 41, 42, 43) auf Basis einer Zeitreihe der Differenzen,
wobei der Sensor dazu eingerichtet ist, die Messwerte in einem ersten Zeitfenster (51) vor und in einem zweiten Zeitfenster (52) nach dem Schaltvorgang in der einen oder mehreren Stromzuführungsleitungen (28.1, 28.2, 28.3) zu erfassen, wobei Parameter der Zeitfenster (51, 52), insbesondere die Länge der Zeitfenster (51, 52) und der zeitliche Abstand der Zeitfenster (51, 52) zu einem Zeitpunkt (t6, t106) des Schaltvorgangs, einstellbar sind.

11. Steuer- und Messeinrichtung (3) nach Anspruch 10, aufweisend einen Speicher (10) zum Speichern von erfassten Messwerten.

12. Steuer- und Messeinrichtung (3) nach Anspruch 10 oder 11, aufweisend eine Kommunikationsschnittstelle (8) zur Übertragung von erfassten Messwerten in ein Kommunikationsnetzwerk (12) .

13. Computerprogrammprodukt (80) zur Zustandsüberwachung von mindestens einer von zwei oder mehr stromführenden elektrischen Komponenten (18.1, 18.2, 18.3, 41, 42, 43), wobei das Computerprogrammprodukt (80) in einem Prozessor (6) einer Steuer- und Messeinrichtung (3) ausführbar und zur Durchführung eines Verfahrens nach einem der Ansprüche 1 bis 9 ausgebildet ist.

## Claims

1. Method for monitoring the condition of at least one of two or more current-carrying electrical components (18.1, 18.2, 18.3, 41, 42, 43) to which electrical energy can be supplied from an electrical energy source (14) via a common current feed line (20) and from the common current feed line (20) in each case via a separate current supply line (28.1, 28.2, 28.3) which can be opened or closed individually by way of a switching process, having the following steps:
- recording measured values of an electrical variable in the common current feed line (20) before and after a switching process in one or more of the current supply lines (28.1, 28.2, 28.3);
**characterized by** the following steps:
- calculating a difference between a measured value recorded before the switching process and a measured value recorded after the switching process; and
- determining a condition change of at least one of the two or more components (18.1, 18.2, 18.3, 41, 42, 43) on the basis of a time series of differences,
wherein the measured values are recorded in a first time frame (51) before and in a second time frame (52) after the switching process in the one or more current supply lines (28.1, 28.2, 28.3), wherein parameters of the time frames (51, 52), in particular the length of the time frames (51, 52) and the temporal distance of the time frames (51, 52) to a point in time (t6, t106) of the switching process, can be set.

2. Method according to Claim 1, wherein the setting of the parameters of the time frames (51, 52) is selected depending on the application in which the two or more current-carrying electrical components (18.1, 18.2, 18.3, 41, 42, 43) are operated.

3. Method according to Claim 2, wherein the parameters of the time frames (51, 52) are stored in a storage device (10) depending on the application.

4. Method according to one of the preceding claims, wherein a switching process in a first current supply line (28.1, 28.2, 28.3) takes place with a delay to a switching process in a second current supply line (28.1, 28.2, 28.3), in particular with a delay in the range of 10 to 1000 ms.

5. Method according to one of the preceding claims, wherein the measured values are recorded by means of at least one sensor (4) and the recorded measured values are transmitted from the sensor (4) to a processor (6), for further processing of the measured values, via an unclocked direct communication link (24).

6. Method according to one of the preceding claims, wherein control signals for switching a current supply line (28.1, 28.2, 28.3) from a processor (6) which generates the control signals to the current supply line (28.1, 28.2, 28.3) are transmitted via an unclocked direct communication link (26.1, 26.2, 26.3).

7. Method according to one of the preceding claims, wherein recorded measured values are transmitted into a communication network (12) via an interface unit (8).

8. Method according to one of the preceding claims, wherein motor wear on the basis of a switch-on rush, contact wear on the basis of a current profile, or wear of an application operated in an electromotive manner on the basis of a start-up curve of a driving electric motor (41, 42, 43) is determined.

9. Method according to one of the preceding claims, wherein a synchronization effect is detected in a multiphase alternating current by evaluating the current strength in the respective current phases (L1, L2, L3) of the current supply lines (28.1, 28.2, 28.3) and, in response to this, the switching delay between the current phases (L1, L2, L3) is changed in such a way that the contacts (19.1, 19.2, 19.3) of a switching device (18.1, 18.2, 18.3), which switches the current phases (L1, L2, L3), wear evenly.

10. Control and measuring device (3), having
- a sensor (4) for recording measured values of an electrical variable in a current feed line (20) before and after a switching process in one or more current supply lines (28.1, 28.2, 28.3), wherein electrical current is carried to two or more current-carrying electrical components (18.1, 18.2, 18.3, 41, 42, 43) from an electrical energy source (14) via the common current feed line (20) and from the common current feed line (20) in each case via a separate current supply line (28.1, 28.2, 28.3) which can be opened or closed individually by way of the switching process; and
**characterized by**:
- a processor (6) for calculating a difference between a measured value recorded before the switching process and a measured value recorded after the switching process and for determining a condition change of at least one of the two or more components (18.1, 18.2, 18.3, 41, 42, 43) on the basis of a time series of differences,
wherein the sensor is configured to record the measured values in a first time frame (51) before and in a second time frame (52) after the switching process in the one or more current supply lines (28.1, 28.2, 28.3), wherein parameters of the time frames (51, 52), in particular the length of the time frames (51, 52) and the temporal distance of the time frames (51, 52) to a point in time (t6, t106) of the switching process, can be set.

11. Control and measuring device (3) according to Claim 10, having a storage device (10) for storing recorded measured values.

12. Control and measuring device (3) according to Claim 10 or 11, having a communication interface (8) for transmitting recorded measured values into a communication network (12).

13. Computer program product (80) for monitoring the condition of at least one of two or more current-carrying electrical components (18.1, 18.2, 18.3, 41, 42, 43), wherein the computer program product (80) can be executed in a processor (6) of a control and measuring device (3) and is designed to perform a method according to one of Claims 1 to 9.

## Revendications

1. Procédé de contrôle de l'état d'au moins un parmi deux ou plusieurs composants (18.1, 18.2, 18.3, 41, 42, 43) électriques conduisant le courant, auxquels de l'énergie électrique d'une source (14) d'énergie électrique peut être apportée par l'intermédiaire d'une ligne (20) commune d'alimentation en courant et par la ligne (20) commune d'alimentation en courant respectivement par l'intermédiaire d'une ligne (28.1, 28.2, 28.3) distincte d'amenée du courant, qui peut être ouverte ou fermée individuellement par une opération de coupure, comprenant les stades suivants :
- on relève des valeurs de mesure d'une grandeur électrique dans la ligne (20) commune d'alimentation en courant avant et après une opération de coupure dans une ou dans plusieurs lignes (28.1, 28.2, 28.3) d'amenée du courant ;
**caractérisé par** les stades suivants:
- on calcule une différence entre une valeur de mesure relevée avant l'opération de coupure et une valeur de mesure relevée après l'opération de coupure; et
- on détermine une variation d'état d'au moins l'un des deux ou plusieurs composants (18.1, 18.2, 18.3, 41, 42, 43) sur la base d'une série temporelle des différences,
dans lequel on relève les valeurs de mesure dans un premier créneau (51) temporel avant et dans un deuxième créneau (52) temporel après l'opération de coupure dans la une ou les plusieurs lignes (28.1, 28.2, 28.3) d'amenée du courant, dans lequel des paramètres des créneaux (51, 52) temporels, notamment la longueur des créneaux (51, 52) temporels et la distance dans le temps entre les créneaux (51, 52) temporels à un instant (t6, t106) de l'opération de coupure, sont réglables.

2. Procédé suivant la revendication 1, dans lequel on choisit le réglage des paramètres des créneaux (51, 52) temporels en fonction de l'application suivant laquelle on fait fonctionner les deux ou plusieurs composants (18.1, 18.2, 18.3, 41, 42, 43) électriques conduisant le courant.

3. Procédé suivant la revendication 2, dans lequel on met les paramètres des créneaux (51, 52) temporels dans une mémoire (10) en fonction de l'application.

4. Procédé suivant l'une des revendications précédentes, dans lequel une opération de coupure dans une première ligne (28.1, 28.2, 28.3) d'amenée du courant a lieu avec un retard par rapport à une opération de coupure dans une deuxième ligne (28.1, 28.2, 28.3) d'amenée du courant en particulier avec un retard de l'ordre de 10 à 1000 ms.

5. Procédé suivant l'une des revendications précédentes, dans lequel on relève les valeurs de mesure au moyen d'au moins un capteur (4) et une transmission des valeurs de mesure relevées s'effectue du capteur (4) à un processeur (6) pour le traitement ultérieur des valeurs de mesure par une liaison (24) de communication directe non cadencée.

6. Procédé suivant l'une des revendications précédentes, dans lequel une transmission de signaux de commande pour la connexion d'une ligne (28.1, 28.2, 28.3) d'amenée du courant s'effectue d'un processeur (6) créant les signaux de commande à la ligne (28.1, 28.2, 28.3) d'amenée du courant par une liaison (26.1, 26.2, 26.3) de communication directe non cadencée.

7. Procédé suivant l'une des revendications précédentes, dans lequel on transmet des valeurs de mesure relevées par une unité (8) d'interface dans un réseau (12) de communication.

8. Procédé suivant l'une des revendications précédentes, dans lequel on détermine une usure de moteur sur la base d'un rush de mise en circuit, une usure de contact sur la base d'une courbe de courant ou une usure d'une application fonctionnant par moteur électrique sur la base d'une courbe d'accélération d'un moteur (41, 42, 43) électrique d'entraînement.

9. Procédé suivant l'une des revendications précédentes, dans lequel pour un courant alternatif polyphasé, on détecte par une analyse de l'intensité du courant dans les phases (L1, L2, L3) respectives de courant des lignes (28.1, 28.2, 28.3) d'amenée du courant un effet de synchronisation et, en réaction à cela, on modifie le retard de coupure entre les phases (L1, L2, L3) de courant de manière à ce que les contacts (19.1, 19.2, 19.3) d'un appareil (18.1, 18.2, 18.3) de coupure, qui effectue la coupure des phases (L1, L2, L3) de courant, s'usent d'une manière uniforme.

10. Dispositif (3) de commande et de mesure comportant
- un capteur (4) de relevé de valeurs de mesure d'une grandeur électrique dans une ligne (20) d'alimentation en courant avant et après une opération de coupure dans une ou dans plusieurs lignes (28.1, 28.2, 28.3) d'amenée du courant, dans lequel du courant électrique d'une source (14) d'énergie électrique est, par l'intermédiaire de la ligne (20) d'alimentation en courant commune et de la ligne (20) d'alimentation en courant commune respectivement par l'intermédiaire d'une ligne (28.1, 28.2, 28.3) d'amenée du courant distincte, qui peut être ouverte ou fermée individuellement par l'opération de coupure, envoyé à deux ou à plusieurs composants (18.1, 18.2, 18.3, 41, 42, 43) électriques conduisant le courant ; et
**caractérisé par**
- un processeur (6) de calcul d'une différence entre une valeur de mesure relevée avant l'opération de coupure et une valeur de mesure relevée après l'opération de coupure et de détermination d'une variation d'état d'au moins l'un des deux ou plusieurs composants (18.1, 18.2, 18.3, 41, 42, 43) sur la base d'une série temporelle des différences,
dans lequel le capteur est agencé pour relever les valeurs de mesure dans un premier créneau (51) temporel avant et dans un deuxième créneau (52) temporel après l'opération de coupure dans la une ou les plusieurs lignes (28.1, 28.2, 28.3) d'amenée du courant dans lequel des paramètres des créneaux (51, 52) temporels, notamment la longueur des créneaux (51, 52) temporels et la distance dans le temps entre les créneaux (51, 52) temporels à un instant (t6, t106) de l'opération de coupure, sont réglables.

11. Dispositif (3) de commande et de mesure suivant la revendication 10, comportant une mémoire (10) de mise en mémoire de valeur de mesure relevée.

12. Dispositif (3) de commande et de mesure suivant la revendication 10 ou 11, comportant une interface (8) de communication pour la transmission de valeurs de mesure relevée dans un réseau (12) de communication.

13. Produit (80) de programme d'ordinateur pour le contrôle d'état d'au moins de deux ou plusieurs composants (18.1, 18.2, 18.3, 41, 42, 43) électriques conduisant le courant, dans lequel le produit (80) de programme d'ordinateur peut être réalisé dans un processeur (6) d'un dispositif (3) de commande et de mesure et est constitué pour effectuer un procédé suivant l'une des revendications 1 à 9.
